# EUROPEAN PATENT APPLICATION

(11) **EP 4 451 821 A1**
(43) Date of publication of application: **23.10.2024**
(21) Application number: 24151108.8
(22) Date of filing: 10.01.2024
(51) Int. Cl.: H10B 53/30, H10B 12/00

(54) **SEMICONDUCTOR MEMORY DEVICE**

(30) Priority: 20.04.2023 KR 20230052074
(71) Applicant: Samsung Electronics Co., Ltd., Suwon-si, Gyeonggi-do 16677 (KR)
(72) Inventor: LIM, Hanjin, 16677 Suwon-si (KR); HAN, Jinwoo, 16677 Suwon-si (KR); LEE, Kiseok, 16677 Suwon-si (KR); KIM, Keunnam, 16677 Suwon-si (KR); PARK, Seokhan, 16677 Suwon-si (KR); JEONG, Moonyoung, 16677 Suwon-si (KR)
(74) Representative: Marks & Clerk LLP

(57) **Abstract**

A semiconductor memory device includes a bit line (BL) extending in a first direction (D1), an active pattern (AP) on the bit line, the active pattern including first and second vertical portions (VP1, VP2) facing each other in the first direction and a horizontal portion (HP) connecting the first and second vertical portions, first and second word lines (WL1, WL2) on the horizontal portion between the first and second vertical portions, the first and second word lines extending in a second direction (D2) crossing the first direction, a gate insulating pattern (GIL1, GIL2) between the first and second word lines and the active pattern, and a capacitor (CAP) connected to each of the first and second vertical portions, the capacitor including a first electrode pattern (EP1) connected to one of the first and second vertical portions, a second electrode pattern (EP2) on the first electrode pattern, and a ferroelectric pattern (CIL) between the first electrode pattern and the second electrode pattern.

## Description

### BACKGROUND

### 1. Field

The present disclosure relates to a semiconductor memory device, and more particularly, to a semiconductor memory device having improved electrical characteristics and integration.

### 2. Description of the Related Art

Recently, demand for higher integration of semiconductor devices has increased to obtain improved performance and/or low price for user needs. In semiconductor memory devices, higher integration may be particularly required, because integration is a significant factor in determining prices. In two-dimensional or planar semiconductor devices, as the integration degree mainly depends on an area occupied by a unit memory cell, integration is affected by the technique(s) used to form fine patterns. To realize minute patterns, however, an increase in integration of the two-dimensional semiconductor devices may be restricted since it may be necessary to install expensive equipment. Accordingly, semiconductor memory devices for increasing integration, resistance, and current driving capability of semiconductor devices have been proposed.

### SUMMARY

According to example embodiments, a semiconductor memory device may include a bit line extending in a first direction, an active pattern on the bit line, the active pattern including first and second vertical portions facing each other in the first direction and a horizontal portion connecting the first and second vertical portions, first and second word lines disposed on the horizontal portion between the first and second vertical portions and extending in a second direction crossing the first direction, a gate insulating pattern between the first and second word lines and the active pattern, and a capacitor connected to each of the first and second vertical portions, and the capacitor may include a first electrode pattern connected to one of the first and second vertical portions, a second electrode pattern on the first electrode pattern, and a ferroelectric pattern between the first electrode pattern and the second electrode pattern.

According to example embodiments, a semiconductor memory device may include a plurality of bit lines extending in a first direction, active patterns arranged in the first direction on each of the bit lines, each of the active patterns including a horizontal portion parallel to the bit line and a vertical portion vertically protruding from the horizontal portion, a plurality of word lines crossing the bit lines and extending in a second direction, the word lines being respectively disposed on the active patterns arranged in the second direction, first electrode patterns respectively connected to the vertical portions of the active patterns, second electrode patterns disposed on rows of the first electrode patterns arranged in the second direction, each of the second electrode patterns extending in the second direction and parallel to the word lines, and a dielectric pattern between the first electrode patterns and each of the second electrode patterns.

According to example embodiments, a semiconductor memory device may include a peripheral circuit structure including peripheral circuits on a semiconductor substrate and a lower insulating layer covering the peripheral circuits, a plurality of bit lines extending in a first direction on the peripheral circuit structure, active patterns arranged in the first direction on each of the bit lines, each of the active patterns including a horizontal portion parallel to the bit line and a vertical portion vertically protruding from the horizontal portion, a plurality of word lines crossing the bit lines and extending in a second direction, each of the word lines being disposed on the active patterns arranged in the second direction, first electrode patterns connected to the vertical portions of the active patterns, each of the first electrode patterns including a bottom portion connected to the first or second vertical portion and a side wall portion extending from the bottom portion, second electrode patterns disposed on rows of the first electrode patterns arranged in the second direction, each of the second electrode patterns including a line portion extending in the second direction and a filler portion filling a space defined by the bottom portion and the side wall portion of the first electrode pattern, and a ferroelectric pattern between the first electrode patterns and each of the second electrode patterns.

According to an embodiment, a capacitor is connected to each of first and second vertical portions of an active pattern. That is, each of the first and second vertical portions is connected to at least one capacitor. For instance, each of the first and second vertical portions may be connected to a corresponding capacitor (e.g. a separate capacitor may be provided for each of the first and second vertical portions). Alternatively, the first and second vertical portions may be connected to the same capacitor (e.g. the first and second vertical portions may share a capacitor).

At least some of the above and other features of the invention are set out in the claims.

### BRIEF DESCRIPTION OF THE DRAWINGS

Features will become apparent to those of skill in the art by describing in detail example embodiments with reference to the attached drawings, in which:
FIG. 1 illustrates a block diagram of a semiconductor memory device according to some example embodiments of the present disclosure.
FIGS. 2A and 2B illustrate schematic perspective views of a semiconductor memory device according to some example embodiments of the present disclosure.
FIGS. 3A and 3B illustrate circuit schematic diagrams of a cell array of a semiconductor memory device according to some example embodiments of the present disclosure.
FIG. 4 illustrates a top plan view of a semiconductor memory device according to some example embodiments of the present disclosure.
FIGS. 5A, 5B, 5C, and 5D illustrate cross-sectional views along lines A-A', B-B', C-C', and D-D', respectively, of FIG. 4.
FIGS. 6A, 6B, and 6C illustrate enlarged views of portion 'P1' of FIG. 5A.
FIG. 7 illustrates a cross-sectional view along line A-A' of FIG. 4 according to some example embodiments of the present disclosure.
FIG. 8A illustrates a plan view of a semiconductor memory device according to some example embodiments of the present disclosure.
FIG. 8B illustrates cross-sectional views along lines A-A' and B-B' of FIG. 8A according to some example embodiments of the present disclosure.
FIG. 9A illustrates a top plan view of a semiconductor memory device according to some example embodiments of the present disclosure.
FIG. 9B illustrates cross-sectional views along lines A-A' and B-B' of FIG. 9A according to some example embodiments of the present disclosure.
FIGS. 10 and 11 illustrate plan views of semiconductor memory devices according to various example embodiments of the present disclosure.
FIGS. 12A to 22A illustrates plan views of stages in a method of manufacturing a semiconductor memory device according to some example embodiments of the present disclosure.
FIGS. 12B to 22B illustrates cross-sectional views along lines A-A' and B-B' of FIGS. 12A to 22A.
FIGS. 12C to 22C illustrates cross-sectional views along lines C-C' and D-D' of FIGS. 12A to 22A.
FIGS. 23A to 23E illustrates cross-sectional views of stages in a method of manufacturing a capacitor of a semiconductor memory device according to some example embodiments of the present disclosure.
FIGS. 24A and 24B are enlarged views of portion 'P2' of FIG. 23B.
FIG. 25 is an enlarged view of portion 'P3' of FIG. 23C.

### DETAILED DESCRIPTION

Hereinafter, a semiconductor memory device and a method of manufacturing the same according to embodiments of the present disclosure will be described in detail with reference to the accompanying drawings.

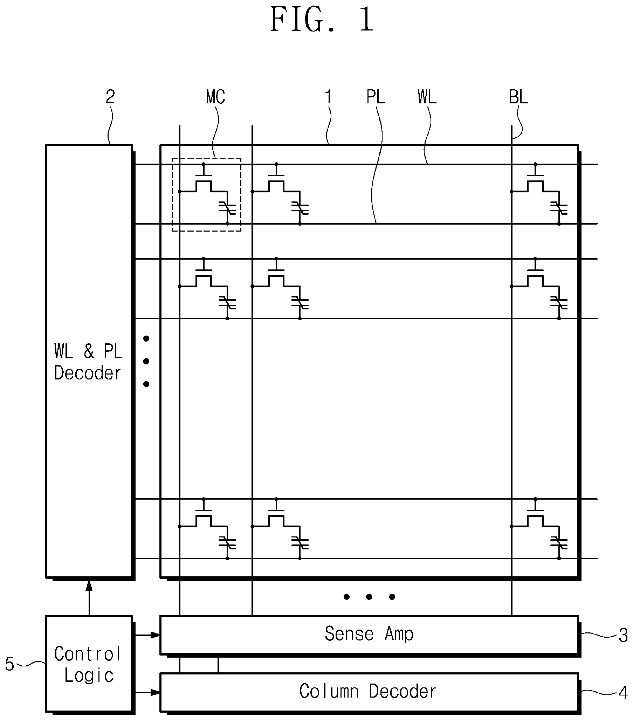

FIG. 1 is a block diagram of a semiconductor memory device according to some example embodiments of the present disclosure.

Referring to FIG. 1, a semiconductor memory device may include a memory cell array 1, a row decoder 2, a sense amplifier 3, a column decoder 4, and a control logic 5.

The memory cell array 1 may include a plurality of memory cells MC arranged two-dimensionally or three-dimensionally. Each of the memory cells MC may be connected between a word line WL and a bit line BL that cross each other. In addition, the memory cells MC forming one row may be connected to each plate line PL.

The row decoder 2 may decode an address, which is externally input to select one of the word lines WL of the memory cell array 1, based on the decoded address information. The address decoded by the row decoder 2 may be provided to a row driver, and in this case, the row driver may provide predetermined voltages to the selected one of the word lines WL and the unselected ones of the word lines WL, respectively, in response to the control of a control circuit.

The sense amplifier 3 may be configured to sense, amplify, and output a difference in voltage between one of the bit lines BL, which is selected based on the address decoded by the column decoder 4, and a reference bit line.

The column decoder 4 may provide a data delivery path between the sense amplifier 3 and an external device (e.g., a memory controller). The column decoder 4 may select one of the bit lines BL by decoding an externally input address.

The control logic 5 may generate control signals, which are used to control data writing or reading operations on the memory cell array 1.

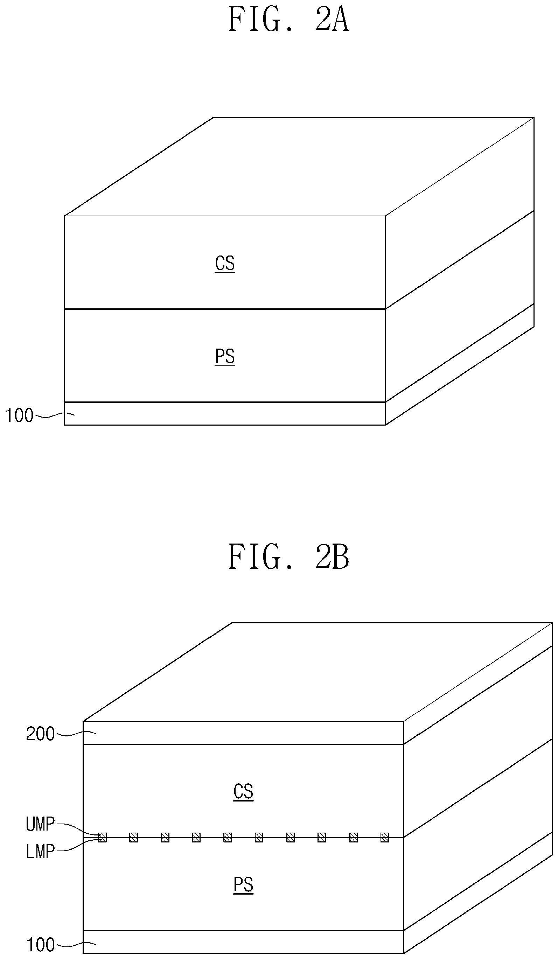

FIGS. 2A and 2B are perspective views schematically illustrating a semiconductor memory device according to some example embodiments of the present disclosure.

For example, referring to FIG. 2A, a semiconductor memory device may include a peripheral circuit structure PS on a semiconductor substrate 100 and a cell array structure CS on the peripheral circuit structure PS.

The peripheral circuit structure PS may include core and peripheral circuits that are formed on the semiconductor substrate 100. The core and peripheral circuits may include row and column decoders (2 and 4 in FIG. 1), a sense amplifier (3 in FIG. 1) and control logics (5 in FIG. 1) described with reference to FIG. 1. The peripheral circuit structure PS may be provided between the semiconductor substrate 100 and the cell array structure CS in a direction (e.g. third direction D3) that is perpendicular to the upper surface of the semiconductor substrate 100. The third direction D3 may be a vertical direction. Discussion herein of relative heights (e.g. upper levels that are higher than lower levels) may be in relation to the third direction D3 (e.g. higher levels may be further along the third direction D3 (e.g. further from the upper surface of the semiconductor substrate 100) than lower levels). It will be appreciated that any directions discussed herein are in relation to the structure of the semiconductor memory device and need not imply any particular orientation of the semiconductor memory device in use.

The cell array structure CS may include the memory cell array 1 described with reference to FIG. 1. That is, the cell array structure CS may include the bit lines BL, word lines WL, and memory cells MC therebetween, as shown in FIG. 1.

In another example, referring to FIG. 2B, the peripheral circuit structure PS may include core and peripheral circuits formed on the first semiconductor substrate 100 and lower metal pads LMP electrically connected thereto. The core and peripheral circuits may include the row and column decoders 2 and 4 (in FIG. 1), the sense amplifier 3 (in FIG. 1), and the control logic 5 (in FIG. 1) described with reference to FIG. 1.

The cell array structure CS may include the memory cell array 1 (in FIG. 1) including the memory cells MC (in FIG. 1) arranged two-dimensionally or three-dimensionally on a second semiconductor substrate 200. The cell array structure CS may include upper metal pads UMP electrically connected to the memory cell array 1 (in FIG. 1).

Lower and upper metal pads LMP and UMP may have substantially the same size and arrangement. The lower and upper metal pads LMP and UMP may be formed of, e.g., copper (Cu), aluminum (Al), nickel (Ni), cobalt (Co), tungsten (W), titanium (Ti), or tin (Sn), or alloys thereof.

The semiconductor memory device may be fabricated by forming the peripheral circuit structure PS including the core and peripheral circuits on the first semiconductor substrate 100, forming the cell array structure CS including the memory cells on the second semiconductor substrate 200, that is distinct from the first semiconductor substrate 100, and then connecting the first semiconductor substrate 100 with the second semiconductor substrate 200 in a bonding manner. In other words, the upper metal pads UMP of the cell array structure CS may be electrically and physically connected to the lower metal pads LMP of the peripheral circuit structure PS, respectively, in a bonding manner. That is, the lower metal pads LMP may be in direct contact with the upper metal pads UMP.

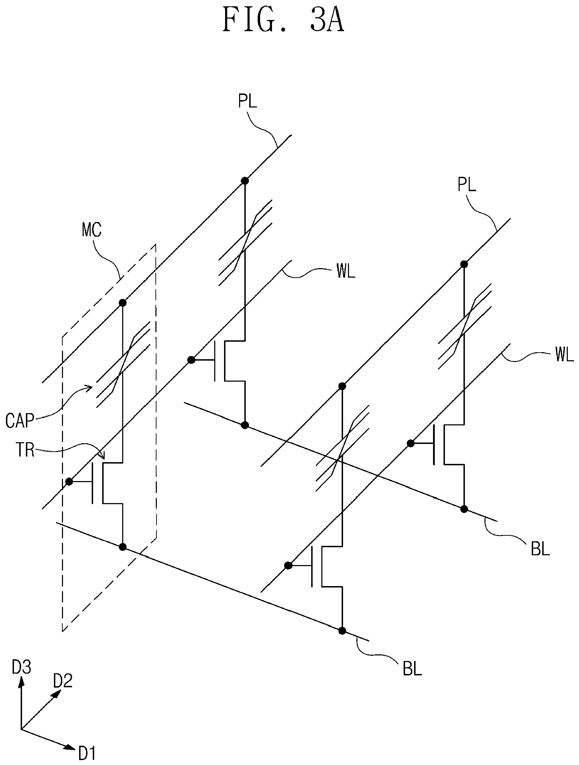

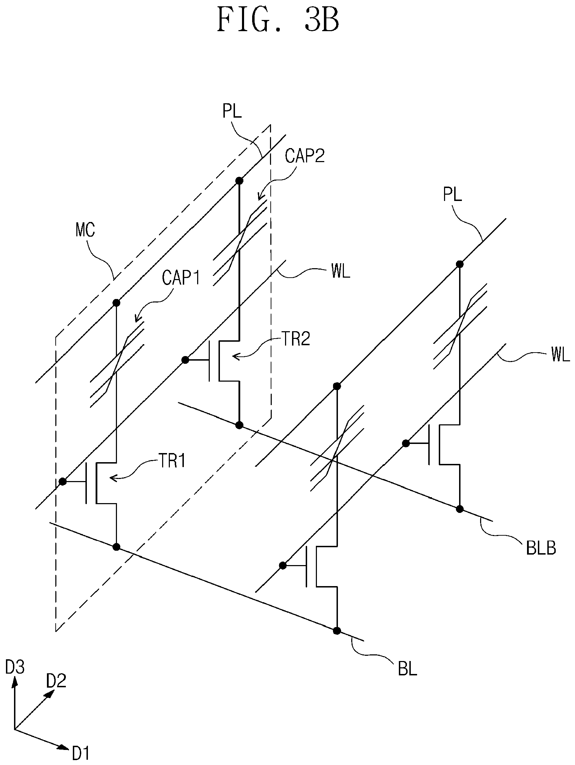

FIGS. 3A and 3B are circuit diagrams schematically illustrating a memory cell array of a semiconductor memory device according to some example embodiments of the present disclosure.

Referring to FIGS. 3A and 3B, a memory cell array of a semiconductor memory device according to some example embodiments of present disclosure may include the memory cells MC arranged in a first direction D1 and a second direction D2 crossing each other.

For example, referring to FIG. 3A, each of the memory cells MC includes one cell transistor TR and one capacitor CAP, and the cell transistor TR and the capacitor CAP may be electrically connected in series. The cell transistor TR may be a vertical channel transistor (VCT) having a channel parallel to a third direction D3 perpendicular to the first direction D1 and the second direction D2.

A gate electrode of the cell transistor TR may be connected to a word line WL, and drain/source terminals of the cell transistor TR may be connected to a bit line BL and a first terminal of the capacitor CAP, respectively. A second terminal of the capacitor CAP may be connected to the plate line PL. The plate line PL may be parallel to the word line WL.

The bit line BL may be connected to source terminals of the cell transistors TR arranged in the first direction D1. The word line WL may be connected to gate electrodes of the cell transistors TR arranged in the second direction D2. The plate line PL may be connected to the second terminals of capacitors CAP arranged in the second direction D2.

The capacitor CAP of each memory cell MC may include a ferroelectric material, an antiferroelectric material, a paraelectric material, or a combination thereof. For example, the capacitor CAP of each memory cell MC may be a ferroelectric capacitor. A polarization state of the ferroelectric material of the ferroelectric capacitor may be changed depending on a voltage applied thereto, and the polarization state of the ferroelectric material may be maintained even when power is cut off. That is, as the ferroelectric capacitor has a non-volatile memory characteristic of retaining data for a predetermined period of time, the area of the capacitor CAP may be reduced and integration of the semiconductor memory device may be improved. In addition, the ferroelectric capacitor may retain data for a predetermined time depending on a voltage applied to the plate line PL.

In another example, referring to FIG. 3B, each of the memory cells MC may include two cell transistors TR1 and TR2 and two capacitors CAP1 and CAP2.

A source terminal of a first cell transistor TR1 of each memory cell MC may be connected to one bit line BL of a pair of bit lines BL and BLB, and a source terminal of a second transistor TR2 may be connected to the other bit line BLB among the pair of bit lines BL and BLB. Signals complementary to each other may be applied to the pair of bit lines BL and BLB connected to each memory cell MC.

The first and second cell transistors TR1 and TR2 may be controlled by one word line WL. In addition, second terminals of first and second capacitors CAP1 and CAP2 of each memory cell MC may be connected to the plate line PL.

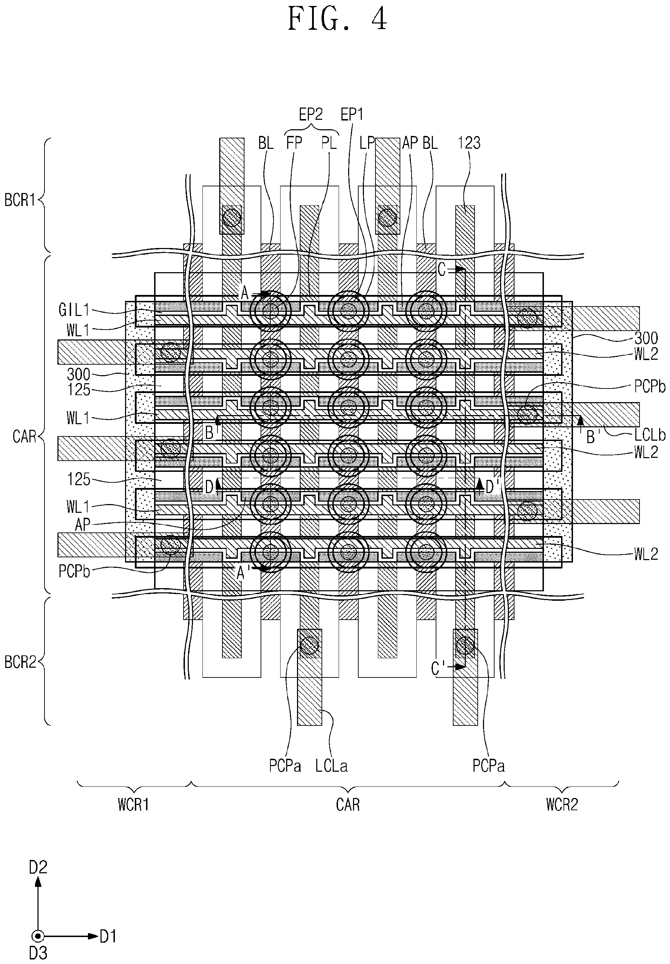

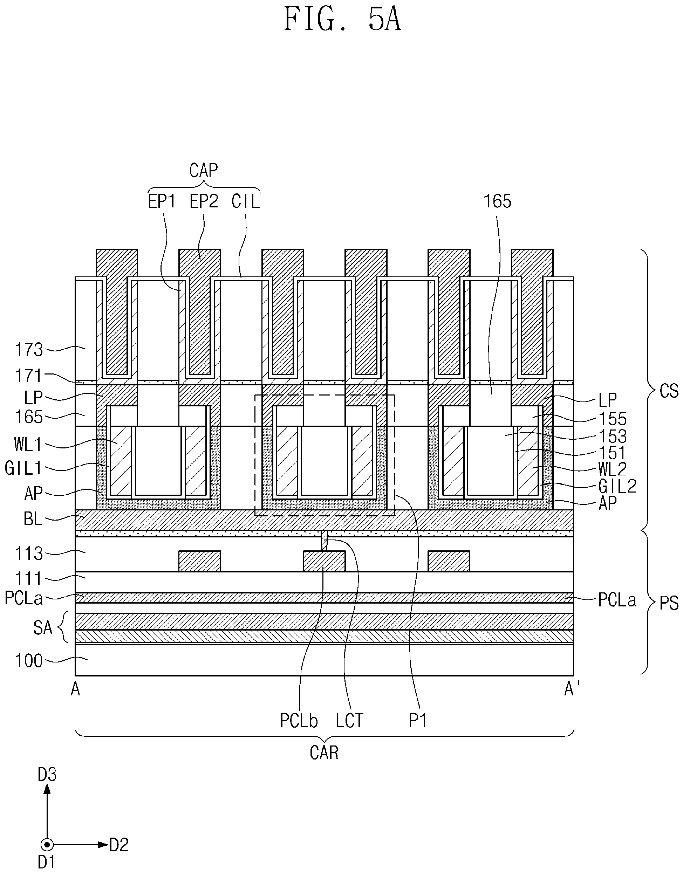

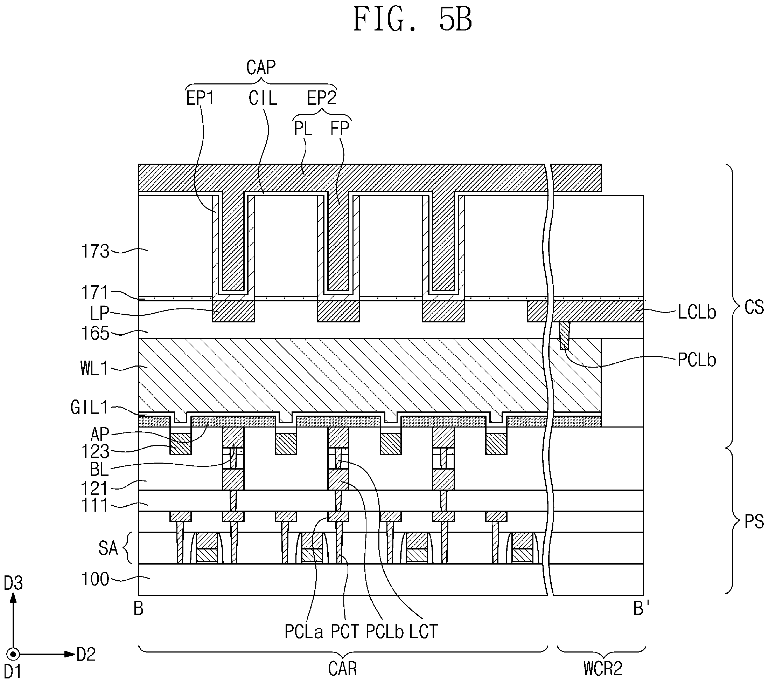

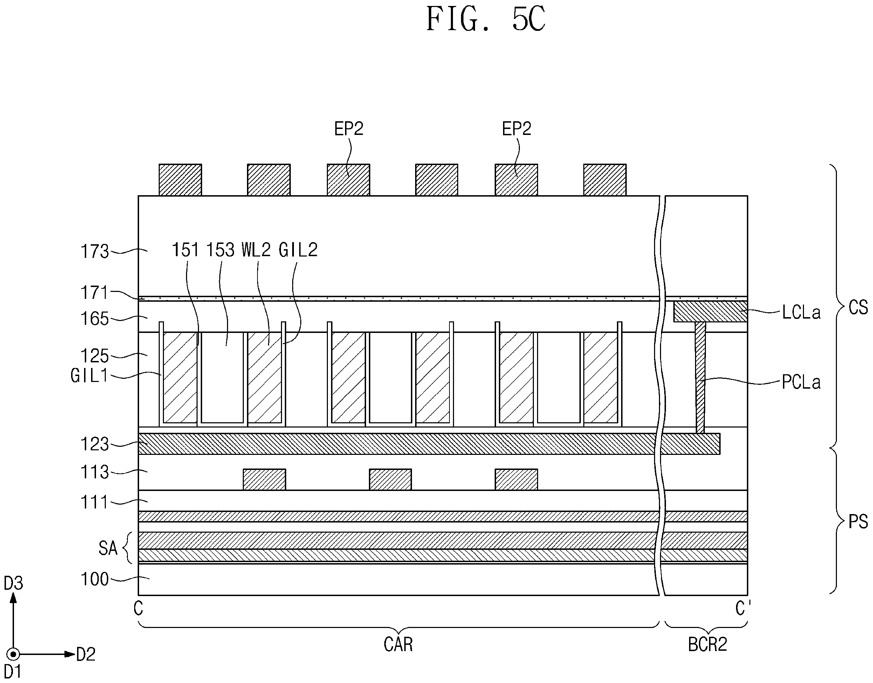

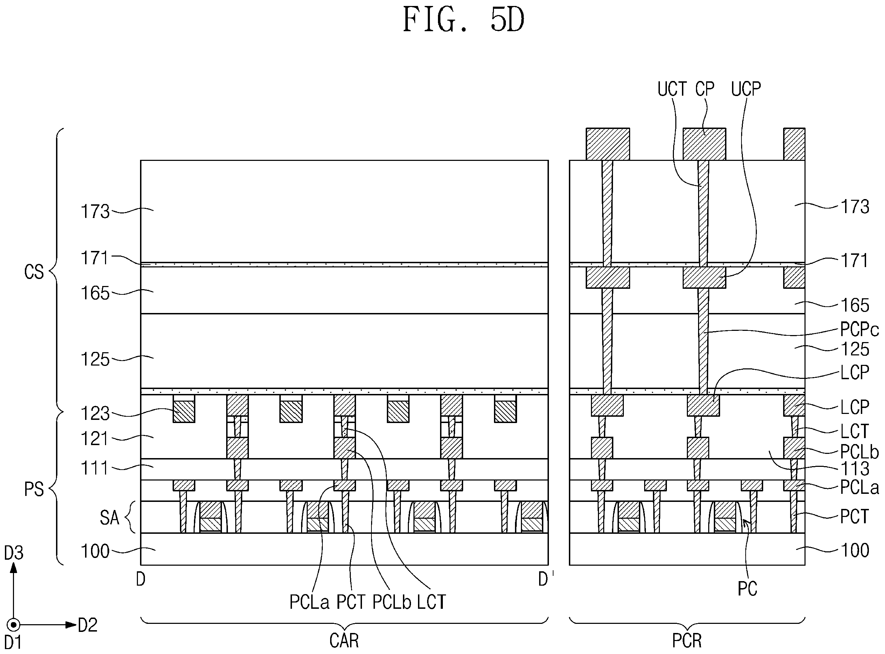

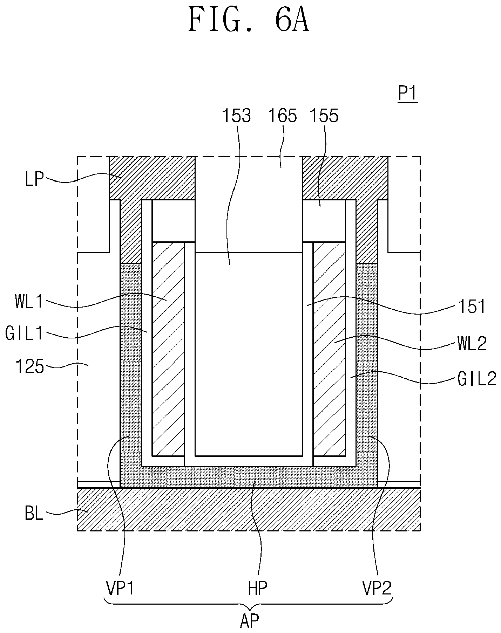

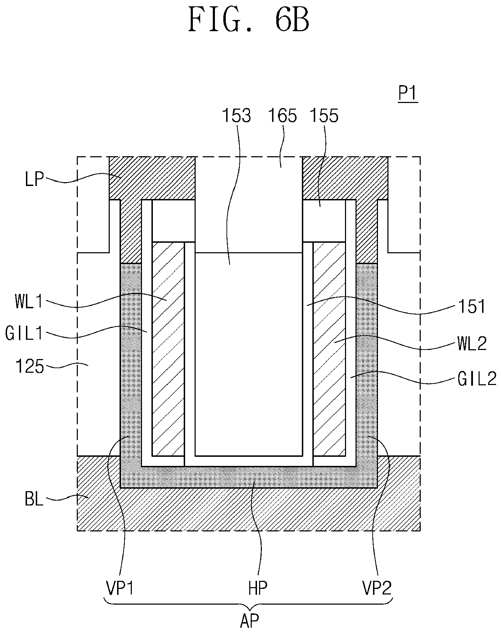

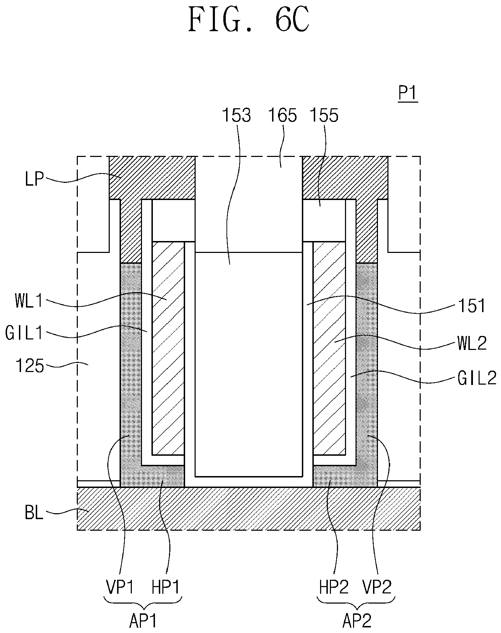

FIG. 4 is a top plan view of a semiconductor memory device according to embodiments of the present disclosure. FIGS. 5A, 5B, 5C, and 5D are cross-sectional views along lines A-A', B-B', C-C', and D-D', respectively, of FIG. 4 according to some example embodiments of the present disclosure. FIGS. 6A, 6B, and 6C are enlarged views of portion `P1' of FIG. 5A.

Referring to FIGS. 4, 5A, 5B, 5C, and 5D, a semiconductor memory device according to embodiments may include a peripheral circuit structure PS and a cell array structure CS on the peripheral circuit structure PS. In addition, the semiconductor memory device may include a cell array region CAR, word line connection regions WCR1 and WCR2, and bit line connection regions BCR1 and BCR2. The cell array region CAR may be provided between the first and second word line connection regions WCR1 and WCR2 in a first direction D1, and may be provided between the first and second bit line connection regions BCR1 and BCR2 in a second direction D2. In this case, the first and second directions D1 and D2 may be parallel to an upper surface of a substrate 100 and may be perpendicular to each other. Hereinafter, the first and second word line connection regions WCR1 and WCR2 may be referred to as first connection regions, and the first and second bit line connection regions BCR1 and BCR2 may be referred to as second connection regions. That is, the first connection regions WCR1 and WCR2 may be provided on both sides of the cell array region CAR in the first direction D1, and the second connection regions BCR1 and BCR2 may be provided on both sides of the cell array region CAR in the second direction D2.

The peripheral circuit structure PS may include core and peripheral circuits SA and PC integrated on the entire surface of the semiconductor substrate 100, peripheral circuit insulating layers 111 and 113 covering the core and peripheral circuits SA and PC, peripheral contact plugs PCT, and peripheral circuit wirings PCLa and PCLb.

The semiconductor substrate 100 may be a single crystal silicon substrate. The core and peripheral circuits SA and PC may include the row and column decoders 2 and 4 (in FIG. 1), the sense amplifier 3 (in FIG. 1), and the control logic 5 (in FIG. 1) described with reference to FIG. 1,

The core circuit SA including the sense amplifier 3 (in FIG. 1) may be provided in the cell array region CAR of the semiconductor substrate 100, and the peripheral circuits PC, e.g., a word driver and control logic 5 (in FIG. 1), may be provided in the peripheral circuit region PCR of the semiconductor substrate 100.

The core and peripheral circuits SA and PC may include NMOS and PMOS transistors integrated on the semiconductor substrate 100. The core and peripheral circuits SA and PC may be electrically connected to the bit lines BL and word lines WL through the peripheral circuit wirings PCLa and PCLb and peripheral circuit contact plugs PCT. The sense amplifiers may be electrically connected to the bit lines BL and each sense amplifier may amplify and output a difference in voltage levels sensed by a pair of bit lines BL.

The peripheral circuit insulating layers 111 and 113 may cover the core and peripheral circuits SA and PC, the peripheral circuit wirings PCLa and PCLb, and the peripheral circuit contact plugs PCT on the semiconductor substrate 100. The peripheral circuit insulating layers 111 and 113 may have a substantially flat upper surface. The peripheral circuit insulating layers 111 and 113 may include multi-layered insulating layers. For example, the peripheral circuit insulating layers 111 and 113 may include a silicon oxide layer, a silicon nitride layer, a silicon oxynitride layer, and/or a low dielectric layer.

The cell array structure CS may be provided on the peripheral circuit insulating layers 111 and 113. The cell array structure CS may include a plurality of bit lines BL, active patterns AP, first and second word lines WL1 and WL2, gate insulating patterns GIL1 and GIL2, and capacitors CAP.

The bit lines BL may be spaced apart from each other in the first direction D1 on the peripheral circuit insulating layers 111 and 113. The bit lines BL may extend parallel to each other in a second direction D2 crossing the first direction D1. The bit lines BL may have a first width in the first direction D1, and the first width may be about 1 nm to about 50 nm (e.g. the first width may be in the range of 1 nm to 50 nm). The bit lines BL may be connected to the peripheral circuit wirings PCLa and PCLb through the lower contact plugs LCT.

The bit lines BL may include, e.g., doped polysilicon, metal, conductive metal nitride, conductive metal silicide, conductive metal oxide, or a combination thereof. The bit lines BL may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof. The bit lines BL may include a single layer or multiple layers of the aforementioned materials. In some embodiments, the bit lines BL may include two-dimensional and three-dimensional materials, e.g., and may include graphene, which is a carbon-based two-dimensional material, and carbon nanotube, which is a three-dimensional material, or a combination thereof.

In the peripheral circuit region PCR, lower conductive patterns LCP may be disposed at the same level as the bit lines BL. The lower conductive patterns LCP may be connected to the peripheral circuit wirings PCLa and PCLb through lower contact plugs LCT. The lower conductive patterns LCP may include the same conductive material as the bit lines BL.

A first insulating pattern 121 may be disposed between the bit lines BL. The first insulating pattern 121 may have a substantially uniform thickness and may cover sidewalls and upper surfaces of the bit lines BL. The first insulating pattern 121 may define gap regions between the bit lines BL, respectively. Gap regions of the first insulating pattern 121 may extend parallel to the bit lines BL in the second direction D2.

The first insulating pattern 121 may extend from the cell array region CAR to the first and second connection regions WCR1, WCR2, BCR1, and BCR2. The first insulating pattern 121 may include, e.g., a silicon oxide layer, a silicon nitride layer, a silicon oxynitride layer, and/or a low dielectric layer.

Shielding lines 123 may be provided between the bit lines BL, and the shielding lines 123 may extend in parallel in the first direction D1. The shielding lines 123 may be provided in the first insulating pattern 121, and upper surfaces of the shielding lines 123 may be positioned at a lower level than upper surfaces of the bit lines BL.

The shielding lines 123 may be formed of a conductive material and may include air gaps or voids therein. For example, the shielding lines 123 may include a metal material, e.g., tungsten (W), titanium (Ti), nickel (Ni), or cobalt (Co). In another example, the shielding lines 123 may include a conductive two-dimensional (2D) material, e.g., graphene. The shielding lines 123 may reduce coupling noise between adjacent bit lines BL.

The shielding lines 123 may extend in the second direction D2 from the cell array region CAR to the second connection regions BCR1 and BCR2 and may have ends at the second connection regions BCR1 and BCR2. In the second direction D2, lengths of the shielding lines 123 may be greater than lengths of the bit lines BL.

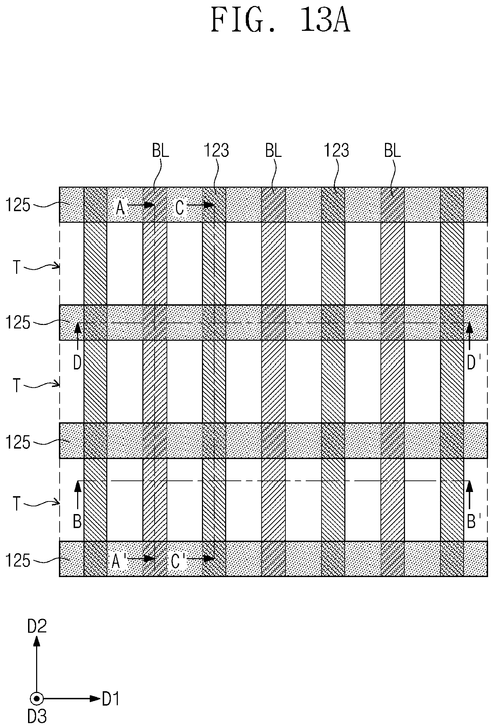

A separation insulating pattern 125 may be disposed on the bit lines BL, the shielding lines 123, and the first insulating pattern 121. The separation insulating pattern 125 may define trenches (refer to T in FIG. 13A) extending in the first direction D1 across the bit lines BL and spaced apart from each other in the second direction D2. The separation insulating pattern 125 may cover upper surfaces of the lower conductive patterns LCP in the peripheral circuit region PCR. The separation insulating pattern 125 may include, e.g., a silicon oxide layer, a silicon nitride layer, a silicon oxynitride layer, and/or a low-k dielectric layer. A low-k dielectric layer may be a layer having a dielectric constant that is lower than that of silicon oxide (e.g. SiO₂).

The active patterns AP may be disposed on the bit lines BL. The active patterns AP may be spaced apart from each other in the first direction D1 by a gate insulating pattern and the shielding lines 123 in trenches between adjacent active patterns AP. The active patterns AP may be spaced apart from each other in the second direction D2 by the separation insulating patterns 125. That is, the active patterns AP may be two-dimensionally arranged in the first direction D1 and the second direction D2 crossing each other.

Each of the active patterns AP may have a second width in the first direction D1 that is substantially equal to or greater than a first width of the bit lines BL in the first direction D1. A distance between the active patterns AP in the second direction D2 may be different from a first length of the active pattern AP in the second direction D2. For example, the distance between the active patterns AP in the second direction D2 may be smaller than the first length of the active pattern AP in the second direction D2. In another example, a distance between the active patterns AP in the second direction D2 may be substantially equal to the first length of the active pattern AP in the second direction D2.

The active patterns AP may include a semiconductor material in a polycrystalline state. The active patterns AP may include, e.g., silicon (Si), germanium (Ge), or silicon-germanium (SiGe). For example, the active patterns AP may be formed of polycrystalline silicon. In another example, the active patterns AP may include an oxide semiconductor, e.g., InₓGa_{y}ZnzO, InₓGa_{y}SizO, InₓSn_{y}ZnzO, InₓZn_{y}O, ZnₓO, ZnₓSn_{y}O, ZnₓO_{y}N, ZrₓZn_{y}SnzO, Sn_{X}O, HfₓIn_{y}ZnzO, GaₓZn_{y}SnzO, AlₓZn_{y}SnzO, YbₓGayZnzO, InₓGa_{y}O, or a combination thereof. For example, the active patterns AP may include indium gallium zinc oxide (IGZO). The active patterns AP may include a single layer or multiple layers of the oxide semiconductor. The active patterns AP may include an amorphous, crystalline, or polycrystalline oxide semiconductor. In some embodiments, the active patterns AP may have a bandgap energy greater than that of silicon. For example, the active patterns AP may have a bandgap energy of about 1.5 eV to about 5.6 eV (e.g. a bandgap energy falling within the range of 1.5 eV to 5.6 eV). For example, the active patterns AP may have optimal channel performance when they have a bandgap energy of about 2.0 eV to about 4.0 eV (e.g. a bandgap energy falling within the range of 2.0 eV to 4.0 eV). For example, the active patterns AP may be polycrystalline or amorphous. In embodiments, the active patterns AP may include a two-dimensional semiconductor material, e.g., graphene, carbon nanotube, or a combination thereof.

For example, referring to FIG. 6A, each of the active patterns AP may include a horizontal portion HP disposed on the bit line BL, and first and second vertical portions VP1 and VP2 vertically protruding from the horizontal portion HP and facing each other in the first direction D1. Each of the first and second vertical portions VP1 and VP2 may have inner and outer walls facing each other, and the inner walls of the first and second vertical portions VP1 and VP2 of a same active pattern AP may face each other in the first direction D1. In addition, the outer walls of the first and second vertical portions VP1 and VP2 of each active pattern AP may be opposed to each other. The outer walls of the first and second vertical portions VP1 and VP2 of the active pattern AP may be in contact with sidewalls of the separation insulating pattern 125.

The first and second vertical portions VP1 and VP2 may have a vertical length in a direction perpendicular to the upper surface of the semiconductor substrate 100 and a width in the first direction D1. For example, the vertical length of the first and second vertical portions VP1 and VP2 may be about 2 times to 10 times greater than the width thereof (e.g. the vertical length of the first and second vertical portions VP1 and VP2 may be 2 times to 10 times greater than the width thereof). The width of the first and second vertical portions VP1 and VP2 in the first direction D1 may be several nm to several tens of nm. For example, the width of each of the first and second vertical portions VP1 and VP2 may be 1 nm to 30 nm, e.g., 1 nm to 10 nm.

The horizontal portions HP of the active patterns AP may be in direct contact with upper surfaces of the bit lines BL. A thicknesses of the horizontal portions HP on the upper surfaces of the bit lines BL, e.g., along the third direction D3, may be substantially the same as a thicknesses of the first and second vertical portions VP1 and VP2 on the sidewalls of the separation insulating pattern 125, e.g., along the first direction D1.

In each of the active patterns AP, the horizontal portion HP may include a common source/drain region, an upper end of the first vertical portion VP1 may include a first source/drain region, and an upper end of the second vertical portion VP2 may include a second source/drain region. The first vertical portion VP1 may include a first channel region between the first source/drain region and the common source/drain region, and the second vertical portion VP2 may include a second channel region between the second source/drain region and the common source/drain region. According to embodiments, the channel region of the first vertical portion VP1 may be controlled by the first word line WL1, and the channel region of the second vertical portion VP2 may be controlled by the second word line WL2. For example, as illustrated in FIG. 6A, the first and second word lines WL1 and WL2 may extend on the inner walls of the first and second vertical portions VP1 and VP2, respectively.

In another example, referring to FIG. 6B, a bottom surface of the horizontal portion HP of the active pattern AP may be positioned at a lower level than the upper surface of the bit line BL, e.g., relative to a bottom of the bit line BL. The upper surface of the bit line BL may be positioned at a higher level than an upper surface of the horizontal portion HP, e.g., relative to the bottom of the bit line BL.

Referring to FIG. 6C, the first and second active patterns AP1 and AP2 on the bit line BL may be spaced apart from each other in the second direction D2. The first and second active patterns AP1 and AP2 on the bit line BL may be disposed in mirror symmetry with each other. The first active pattern AP1 may include a first horizontal portion HP1 in contact with the bit line BL, and a first vertical portion VP1 vertically protruding from the first horizontal portion HP1 and adjacent to the first word line WL1. The second active pattern AP2 may include a second horizontal portion HP2 in contact with the bit line BL and a second vertical portion VP2 vertically protruding from the second horizontal portion HP2 and adjacent to the outer wall of the second word line WL2.

A sidewall of the first horizontal portion HP1 of the first active pattern AP1 may be aligned with a sidewall of the first gate insulating pattern GIL1. Similarly, a sidewall of the second horizontal portion HP2 of the second active pattern AP2 may be aligned with the sidewall of the second gate insulating pattern GIL2.

The first and second word lines WL1 and WL2 may extend in the first direction D1 across the bit lines BL (e.g., into the page of FIG. 6C) and may be alternately arranged in the second direction D2. A pair of first and second word lines WL1 and WL2 may be disposed on the horizontal portion HP between the first and second vertical portions VP1 and VP2 of each active pattern AP.

Each of the first and second word lines WL1 and WL2 may have inner walls and outer walls opposite to the inner walls, and the inner walls of the first and second word lines WL1 and WL2 may be disposed to face each other on the horizontal portion HP. The first word line WL1 may be adjacent to the first channel region of the first vertical portion VP1, and the second word line WL2 may be adjacent to the second channel region of the second vertical portion VP2. Upper surfaces of the first and second word lines WL1 and WL2 may be positioned at a lower level than upper surfaces of the first and second vertical portions VP1 and VP2 of the active patterns AP, e.g., relative to the bottom of the bit line BL. Furthermore, each of the first and second word lines WL1 and WL2 may have a spacer shape. In other words, the first and second word lines WL1 and WL2 may have rounded upper surfaces.

The first and second word lines WL1 and WL2 may have a third width smaller than the first width of the bit lines BL in the second direction D2. The third width of the first and second word lines WL1 and WL2 may be about 1 nm to about 50 nm (e.g. may be in the range of 1 nm to 50 nm).

The first and second word lines WL1 and WL2 may include, e.g., doped polysilicon, metal, conductive metal nitride, conductive metal silicide, conductive metal oxide, or a combination thereof. The first and second word lines WL1 and WL2 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof. The first and second word lines WL1 and WL2 may include a single layer or multiple layers of the aforementioned materials. In some embodiments, the first and second word lines WL1 and WL2 may include a two-dimensional semiconductor material, e.g., graphene, carbon nanotubes, or a combination thereof.

The first and second word lines WL1 and WL2 may extend from the cell array region CAR to the first connection regions WCR1 and WCR2, e.g., in the first direction D1. As illustrated in FIG. 4, each of the first and second word lines WL1 and WL2 may include a line portion extending in the first direction D1 on the cell array region CAR and an end portion extending in the second direction D2 on the first connection regions WCR1 and WCR2 and connected to the line portion. The end portions of the first and second word lines WL1 and WL2 may be disposed in different first connection regions WCR1 and WCR2. Word line contact plugs PCPb may be connected to the first and second word lines WL1 and WL2 in the first connection regions WCR1 and WCR2. For example, in the first word line connection region WCR1, the word line contact plugs PCPb may be respectively connected to the second word lines WL2. In the second word line connection region WCR2, the word line contact plugs PCPb may be respectively connected to the first word lines WL1.

The first gate insulating pattern GIL1 may be disposed between the first word line WL1 and the active pattern AP, and the second gate insulating pattern GIL2 may be disposed between the second word line WL2 and the active pattern AP. The first and second gate insulating patterns GIL1 and GIL2 may extend parallel to the first and second word lines WL1 and WL2 in the first direction D1. The first and second gate insulating patterns GIL1 and GIL2 may cover surfaces of the active patterns AP with a uniform thickness. The gate insulating pattern between adjacent active patterns AP in the first direction D1 may be in direct contact with an upper surface of the first insulating pattern 121 and the sidewalls of the separation insulating pattern 125.

Each of the first and second gate insulating patterns GIL1 and GIL2 may have a substantial 'L' shape cross-section. That is, like the first and second word lines WL1 and WL2, each of the first and second gate insulating patterns GIL1 and GIL2 may include a horizontal portion covering the horizontal portion HP and a vertical portion covering the first and second vertical portions VP1 and VP2. In addition, the first gate insulating pattern GIL1 and the second gate insulating pattern GIL2 may be disposed to have a mirror symmetry with each other in the second direction D2.

The first and second gate insulating patterns GIL1 and GIL2 may be formed of, e.g., a silicon oxide layer, a silicon oxynitride layer, a high dielectric layer (e.g. a layer having a higher dielectric constant than a silicon oxide layer), or a combination thereof. The high dielectric layer may be formed of, e.g., metal oxide or metal oxynitride. For example, the high dielectric layer usable as a gate insulating layer may be formed of HfO₂, HfSiO, HfSiON, HfTaO, HfTiO, HfZrO, ZrO₂, Al₂O₃, or a combination thereof.

A first capping pattern 151 and a second insulating pattern 153 may be disposed between the pair of first and second word lines WL1 and WL2. The first capping pattern 151 may be disposed between the sidewalls of each of the first and second word lines WL1 and WL2 and the second insulating pattern 153, and between the upper surface of the horizontal portion HP of the active pattern AP and the second insulating pattern 153. The first capping pattern 151 may have a substantially uniform thickness and may be formed of an insulating material different from that of the second insulating pattern 153. The first capping pattern 151 and the second insulating pattern 153 may extend in the first direction D1.

A second capping pattern 155 may be provided on upper surfaces of the first and second vertical portions VP1 and VP2 of the first and second word lines WL1 and WL2. The second capping pattern 155 may cover upper surfaces of the first capping pattern 151 and the second insulating pattern 153. The second capping pattern 155 may extend in the second direction D2. The second capping pattern 155 may be formed of an insulating material different from that of the second insulating pattern 153.

Referring back to FIGS. 4, 5A, 5B, 5C, and 5D, landing pads LP may be disposed on the first and second vertical portions VP1 and VP2 of the active patterns AP. The landing pads LP may be in direct contact with the first and second vertical portions VP1 and VP2. Portions of the landing pads LP may be interposed between the sidewalls of the separation insulating pattern 125 and the sidewalls of the gate insulating patterns GIL1 and GIL2, as shown in FIG. 6A. Bottom surfaces of the landing pads LP may be positioned at a lower level than the upper surfaces of the first and second word lines WL1 and WL2, e.g., relative to the bottom of the bit line BL, as further shown in FIG. 6A.

The landing pads LP may have various shapes, e.g., a circular shape, an elliptical shape, a rectangular shape, a square shape, a rhombic shape, and a hexagonal shape, when viewed in a plan view. For example, the landing pads LP may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof.

A third insulating pattern 165 may be filled between the landing pads LP. In other words, the landing pads LP may be separated from each other, e.g., in the second direction D2, by the third insulating pattern 165.

In addition, upper conductive patterns UCP may be disposed on the separation insulating pattern 125 of the peripheral circuit region PCR. The upper conductive patterns UCP may be positioned at the same level as the landing pads LP and may include the same conductive material as that of the landing pads LP. The upper conductive patterns UCP may be connected to the lower conductive patterns LCP through peripheral contact plugs PCPc.

Capacitors CAP may be respectively disposed on the landing pads LP. Each of the capacitors CAP may include a first electrode pattern EP1, a second electrode pattern EP2, and a capacitor dielectric layer CIL.

The first electrode patterns EP1 of the capacitors CAP may pass through a mold insulating layer 173 and be connected to the landing pads LP, respectively. An etch stop layer 171 may be disposed between the mold insulating layer 173 and the third insulating pattern 165. The mold insulating layer 173 may include, e.g., a silicon oxide layer, a silicon nitride layer, a silicon oxynitride layer, and/or a low dielectric layer. The etch stop layer 171 may include an insulating material having etch selectivity with respect to the mold insulating layer 173.

Each of first electrode patterns EP1 may include a bottom portion connected to the first or second vertical portion and a side wall portion extending from the bottom portion. The sidewall portion and the bottom portion of each first electrode pattern EP1 may have a substantially uniform thickness.

For example, each of the first electrode patterns EP1 may have a long axis in the third direction D3 and may have a hollow cylinder shape (e.g. a cup shape, or a cylinder with one closed end and one open end). In another example, the first electrode patterns EP1 may have a pillar shape. The first electrode patterns EP1 may include at least one of, e.g., a metal material, a metal nitride layer, and a metal silicide.

The capacitor dielectric layer CIL may conformally cover surfaces of the first electrode patterns EP1. The capacitor dielectric layer CIL may include a ferroelectric material, an antiferroelectric material, a paraelectric material, or a combination thereof. For example, the ferroelectric material may include a perovskite material, e.g., BaTiOₓ, a fluorite material based on hafnium (Hf), and a HfₓZr₁₋ₓO_{y} material. For example, the antiferroelectric material may include ZrO₂, HfₓZr₁₋ₓO_{y}, PbZrO₃, and NaNbO₃. The ferroelectric or antiferroelectric material may be a fluorite material based on hafnium (Hf) or may include a La-based rare earth element in an HfₓZr₁₋ₓO_{y} material. The paraelectric material may include high dielectric materials, e.g., BeO₂, MaO₂, CaO₂, SrO₂, Al₂O₃, Y₂O₃, Sc₂O₃, La₂O₃, HfO₂, ZrO₂, TiO₂, Ta₂O₅, Nb₂O₅, V₂O₅, SrTiO₃, and BaSrTiO₃.

For example, the capacitor dielectric layer CIL may have a ferroelectric pattern formed of a ferroelectric material, e.g., the capacitor dielectric layer CIL may be a ferroelectric pattern. A polarization state of the ferroelectric material may be changed depending on a voltage applied thereto, and the polarization state of the ferroelectric material may be maintained even when power is cut off. Accordingly, data stored in the ferroelectric pattern may be maintained for a predetermined time depending on the voltage applied to the second electrode pattern EP2.

The second electrode patterns EP2 may be respectively disposed on rows of the first electrode patterns EP1 arranged in the first direction D1. Each of the second electrode patterns EP2 may include a line portion PL extending in the first direction D1 and filler portions FP filling a space defined by a bottom portion and a sidewall portion of the first electrode pattern EP1. In embodiments, the line portions of the second electrode patterns EP2 may extend in the first direction D1 parallel to the first and second word lines WL1 and WL2.

Furthermore, according to embodiments, trimming patterns 300 may be provided on the first connection regions WCR1 and WCR2, respectively. The trimming patterns 300 may vertically penetrate the first and second word lines WL1 and WL2 in each of the first connection regions WCR1 and WCR2. Each trimming pattern 300 may be commonly provided to end portions of the first and second word lines WL1 and WL2.

The first and second word lines WL1 and WL2 may be electrically separated from each other by the trimming patterns 300 in the first connection regions WCR1 and WCR2. The trimming patterns 300 may include, e.g., a silicon oxide layer, a silicon nitride layer, a silicon oxynitride layer, and/or a low dielectric layer.

Word line contact plugs PCPb connected to the first and second word lines WL1 and WL2 may be disposed in the first connection regions WCR1 and WCR2. The word line contact plugs PCPb may be connected to the second lower connection lines LCLb.

Shielding line contact plugs PCPa connected to the shielding lines 123 may be disposed in the second connection regions BCR1 and BCR2. The shielding line contact plugs PCPa may be connected to the first lower connection line LCLa.

The first and second lower connection lines LCLa and LCLb may be positioned at the same level as the landing pads LP and may include the same conductive material as that of the lading pads LP.

A peripheral conductive pattern CP may be disposed on the mold insulating layer 173 in the peripheral circuit region PCR, and the peripheral conductive pattern CP may be connected to upper conductive patterns UCP through an upper contact plug UCT. The peripheral conductive pattern CP may be positioned on the same level as the second electrode patterns EP2 of the cell array region CAR and may include the same conductive material as that of the second electrode patterns EP2.

Hereinafter, a semiconductor device according to various embodiments of the present disclosure will be described. For brevity of description, descriptions of the same technical features as those of the semiconductor device described above will be omitted, and mainly differences between the embodiments will be described.

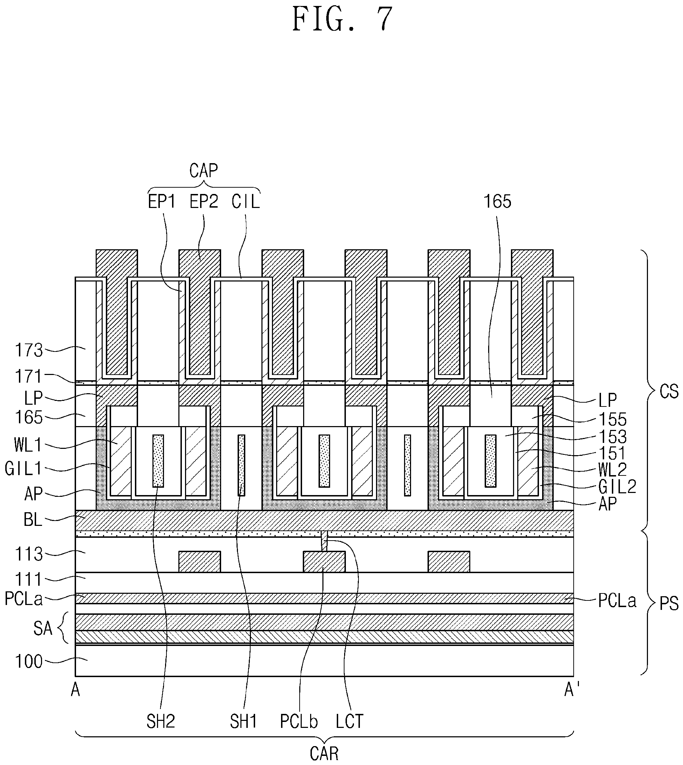

FIG. 7 is a cross-sectional view of a semiconductor memory device according to some example embodiments of the present disclosure, and is a cross-sectional view taken along line A-A' of FIG. 4.

Referring to FIGS. 4 and 7, first air gaps SH1 may be respectively provided between adjacent active patterns AP. The first air gaps SH1 may extend in parallel in the first direction D1. Second air gaps SH2 may be provided between the first and second word lines WL1 and WL2 adjacent to each other, respectively. The second air gaps SH2 may extend parallel to the first and second word lines WL1 and WL2 in the first direction D1. The second air gaps SH2 may be locally formed in the second insulating pattern 153 by depositing an insulating layer using a deposition method having poor step coverage characteristics when forming the second insulating pattern 153.

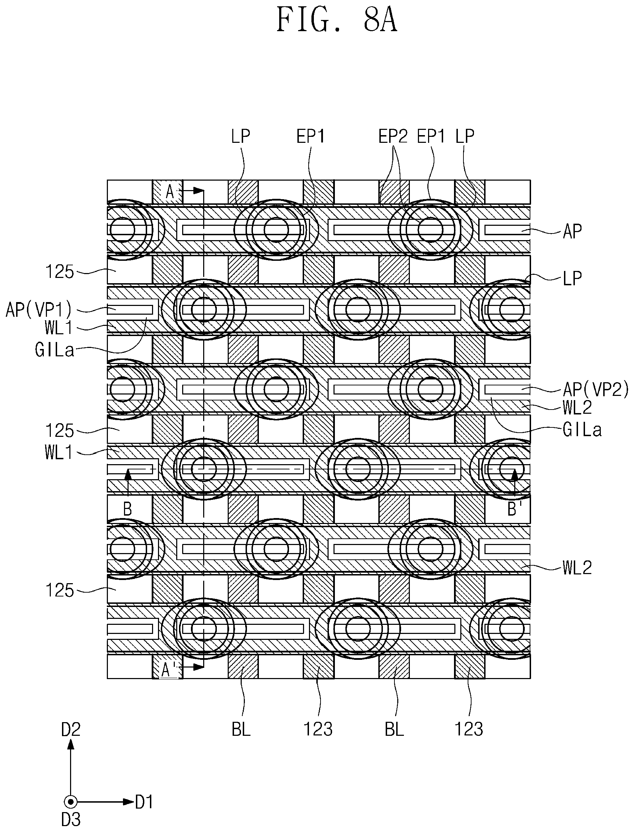

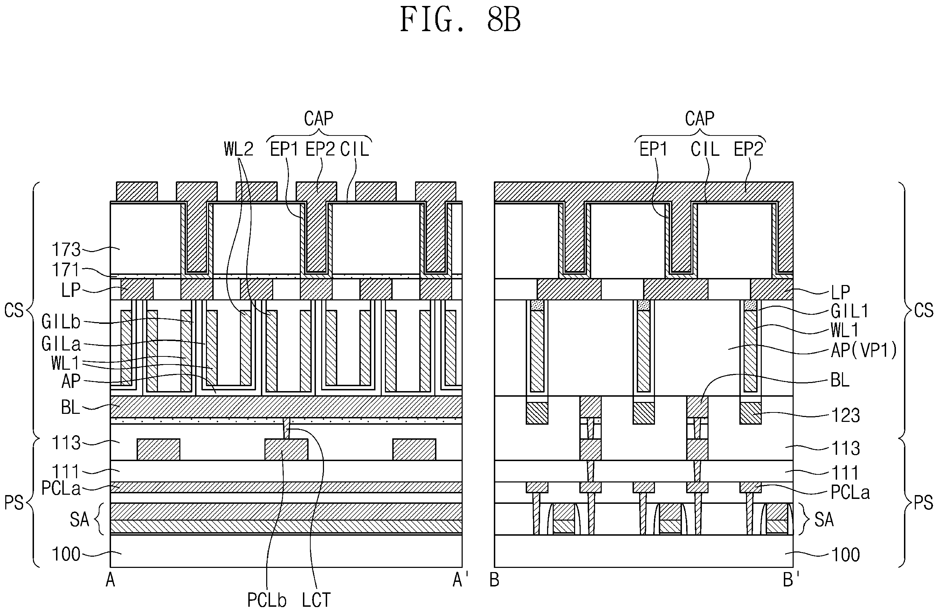

FIG. 8A is a plan view of a semiconductor memory device according to some example embodiments of the present disclosure. FIG. 8B illustrates cross-sectional views along lines A-A' and B-B' of FIG. 8A.

According to the embodiments illustrated in FIGS. 8A and 8B, the active patterns AP may be disposed on the bit lines BL. The active patterns AP may be spaced apart from each other in the first direction D1 on each bit line BL. That is, the active patterns AP may be two-dimensionally arranged in the first direction D1 and the second direction D2 crossing each other.

As described above, the active patterns AP may include the horizontal portion HP disposed on the bit line BL, and the first and second vertical portions VP1 and VP2 that protrude vertically from the horizontal portion HP and face each other in the first direction D1. The first and second word lines WL1 and WL2 may extend in the first direction D1 across the bit lines BL and may be alternately arranged in the second direction D2. Each of the first word lines WL1 may extend while surrounding the first vertical portions VP1 of the active patterns AP arranged in the first direction D1. Each of the second word lines WL2 may extend while surrounding the second vertical portions VP2 of the active patterns AP arranged in the first direction D1.

In one example, each of the first and second word lines WL1 and WL2 may include inner and outer gate electrodes. The inner gate electrode may be disposed on the horizontal portion HP of the active pattern AP and may be adjacent to inner walls of the first and second vertical portions VP1 and VP2. The outer gate electrode may be adjacent to outer walls of the first and second vertical portions VP1 and VP2 of the active pattern AP.

One first or second vertical portion VP1 or VP2 may be disposed between the inner gate electrode and the outer gate electrode. That is, the semiconductor memory device may have a double gate transistor structure.

An inner gate insulating pattern GILa may cover the inner wall of the active pattern AP with a uniform thickness, and an outer gate insulating pattern GILb may cover the outer wall of the active pattern AP with a uniform thickness. The outer gate insulating pattern GILb may be in contact with the bit line BL between adjacent outer gate electrodes. The inner gate insulating pattern GILa may cover the horizontal portion HP of the active pattern AP.

The landing pads LP may be respectively disposed on the first and second vertical portions VP1 and VP2 of the active patterns AP. The landing pads LP may be disposed on centers of the first and second vertical portions VP1 and VP2, respectively, and may be arranged in a matrix form when viewed in a plan view.

The landing pads LP may be electrically connected to the first and second vertical portions VP1 and VP2, and may be displaced from the centers of the first and second vertical portions VP1 and VP2. That is, the landing pads LP may be arranged in a zigzag or honeycomb shape. Each of the landing pads LP may have an elliptical shape having a long axis in the first direction D1 when viewed in a plan view.

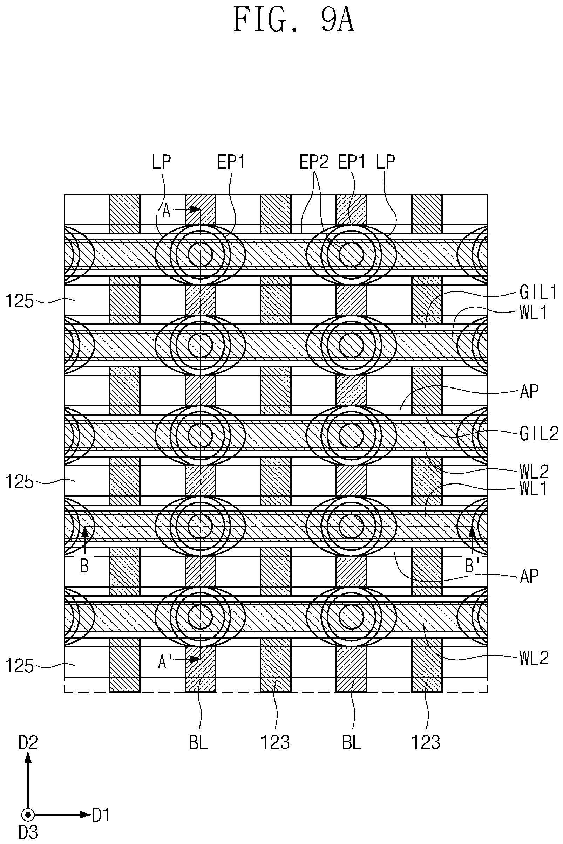

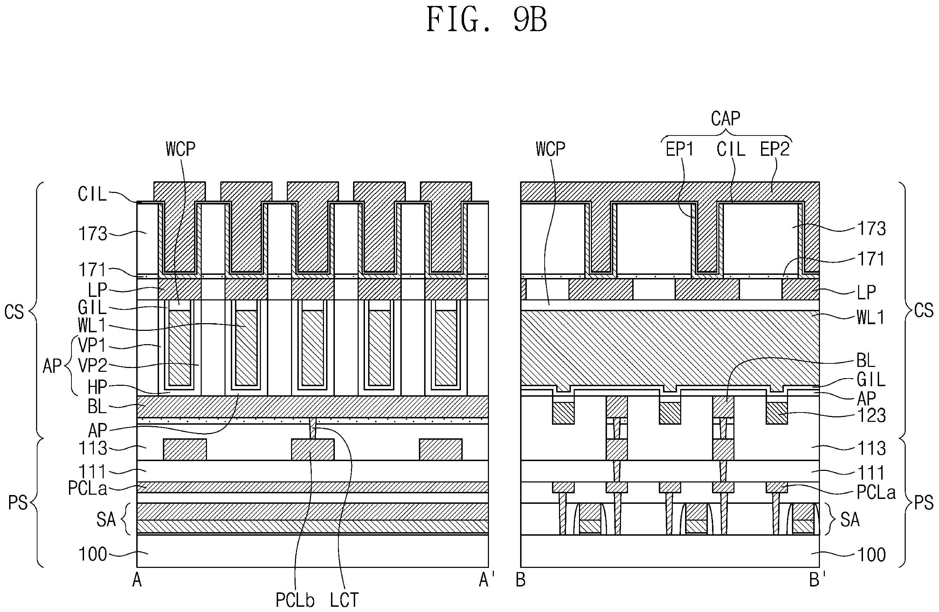

FIG. 9A is a top plan view of a semiconductor memory device according to some example embodiments of the present disclosure. FIG. 9B illustrates cross-sectional views along lines A-A' and B-B' of FIG. 9A.

According to the embodiments shown in FIGS. 9A and 9B, the bit lines BL may extend in the second direction D2 on the peripheral circuit structure PS and may be spaced apart from each other in the first direction D1.

The first and second word lines WL1 and WL2 may extend in the first direction D1 on the bit lines BL. The first and second word lines WL1 and WL2 may be alternately arranged in the second direction D2. Here, a width of each of the first and second word lines WL1 and WL2 may be greater than half of a distance between the first and second vertical portions VP1 and VP2 of each active pattern AP.

The active patterns AP may be disposed between the first and second word lines WL1 and WL2 and the bit lines BL, respectively. The active patterns AP may be disposed spaced apart from each other in the first direction D1 on each bit line BL. As described above, each of the active patterns AP may include the first and second vertical portions VP1 and VP2 facing each other, and a horizontal portion HP connecting the first and second vertical portions VP1 and VP2. The horizontal portion HP may be in contact with the upper surface of the bit line BL, and the first and second vertical portions VP1 and VP2 may be adjacent to sidewalls of the first or second word line WL1 or WL2. A word line capping pattern WCP may be disposed on an upper surface of each of the first and second word lines WL1 and WL2. The upper surfaces of the first and second word lines WL1 and WL2 may be positioned at a level lower than upper surfaces of the first and second vertical portions VP1 and VP2 of the active patterns AP. According to these embodiments, the channel regions of the first and second vertical portions VP1 and VP2 of each active pattern AP may be commonly controlled by the first or second word lines WL1 or WL2.

A gate insulating pattern GIL may be interposed between sidewalls and a bottom surface of each of the first and second word lines WL1 and WL2 and the active pattern AP. The gate insulating pattern GIL may be in direct contact with the sidewalls and bottom surface of each of the first and second word lines WL1 and WL2.

The active patterns AP may be separated from each other in the first direction D1 by the separation insulating patterns 125.

The landing pads LP may be provided on the active patterns AP, respectively, and each landing pad LP may be connected to the first and second vertical portions VP1 and VP2 in common.

The capacitors CAP may be disposed on the landing pads LP, respectively, and each capacitor CAP may be commonly connected to the first and second vertical portions VP1 and VP2 of the corresponding active pattern AP through the landing pad LP. The capacitors CAP may be disposed at intersections of first and second word lines WL1 and WL2 and bit lines BL when viewed in a plan view. That is, the capacitors CAP may be arranged in a matrix form in the first direction D1 and the second direction D2. As another example, the capacitors CAP may be arranged in a zigzag or honeycomb shape when viewed in a plan view.

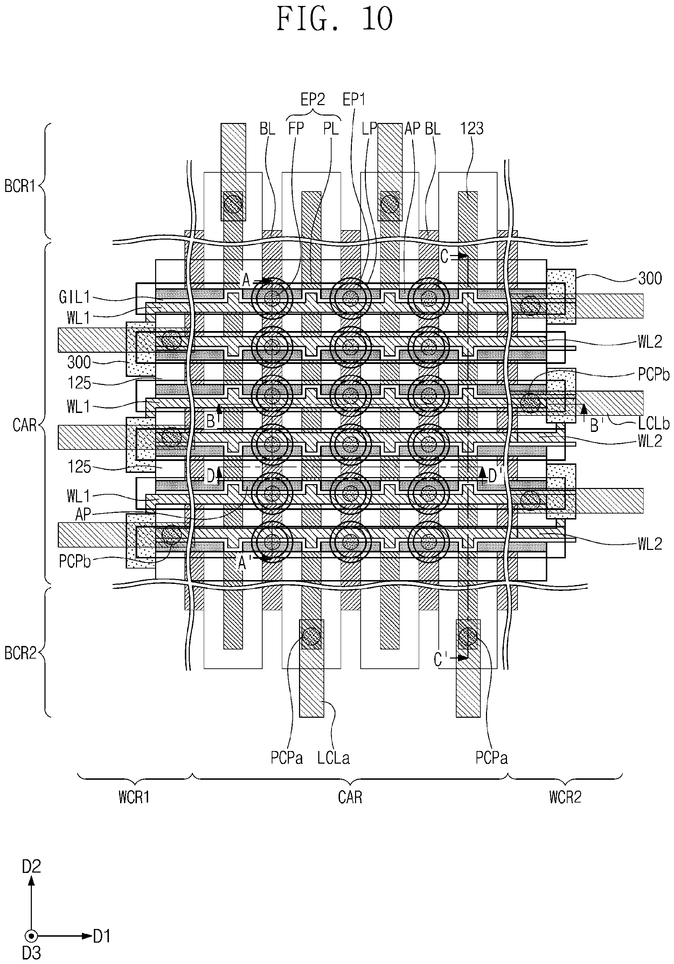

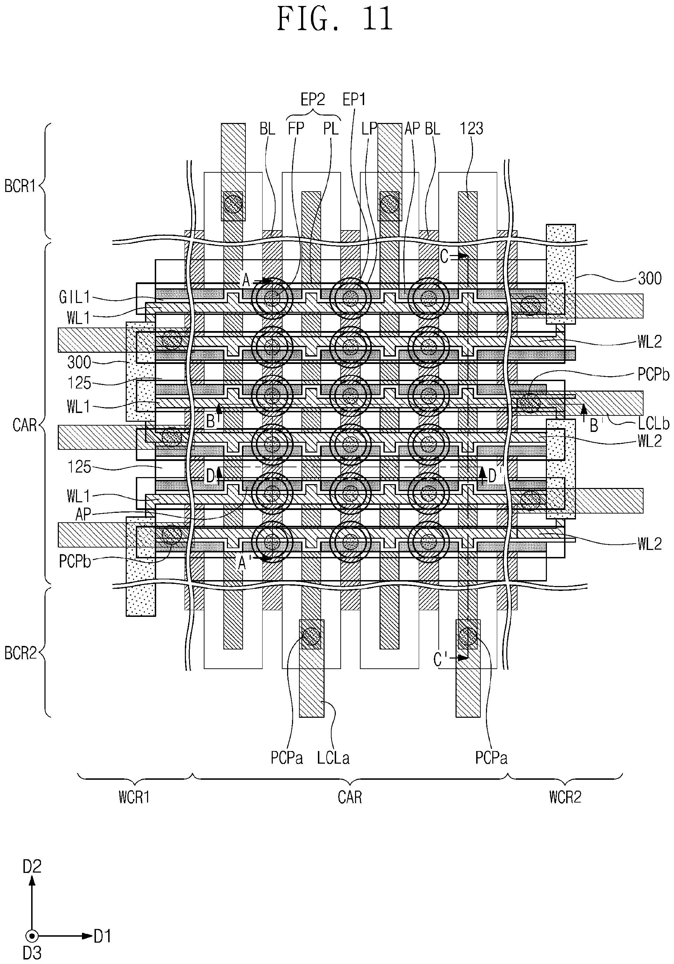

FIGS. 10 and 11 are plan views of semiconductor memory devices according to various example embodiments of the present disclosure.

According to the embodiments shown in FIG. 10, the trimming patterns 300 in each of the first connection regions WCR may be disposed between a pair of adjacent first and second word lines WL1 and WL2. Each of the first and second word lines WL1 and WL2 may include a line portion extending in the first direction D1 and a protruding portion extending in the second direction D2 and connected to the line portion. The word line contact plugs PCPb may be connected to the protruding portions of the second word lines WL2 in the first word line connection region WCR1 and may be connected to the protruding portions of the first word lines WL1 in the second word line connection region WCR2.

According to the embodiments shown in FIG. 11, a length of each trimming pattern 300 in the second direction D2 in the word line connection regions WCR1 and WCR2 may be greater than a width of the separation insulating pattern 125 in the second direction D2.

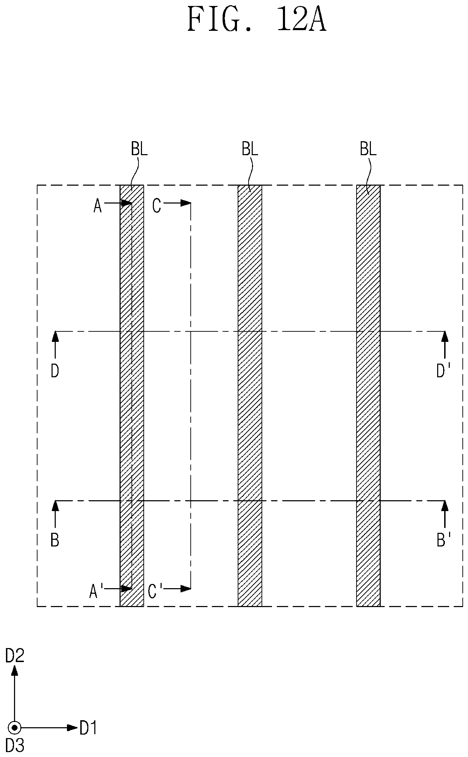

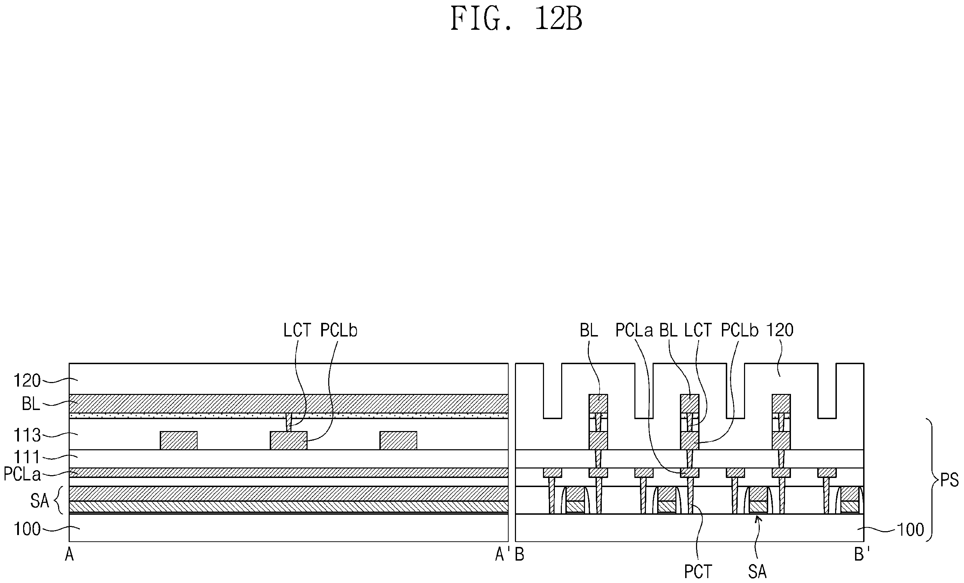

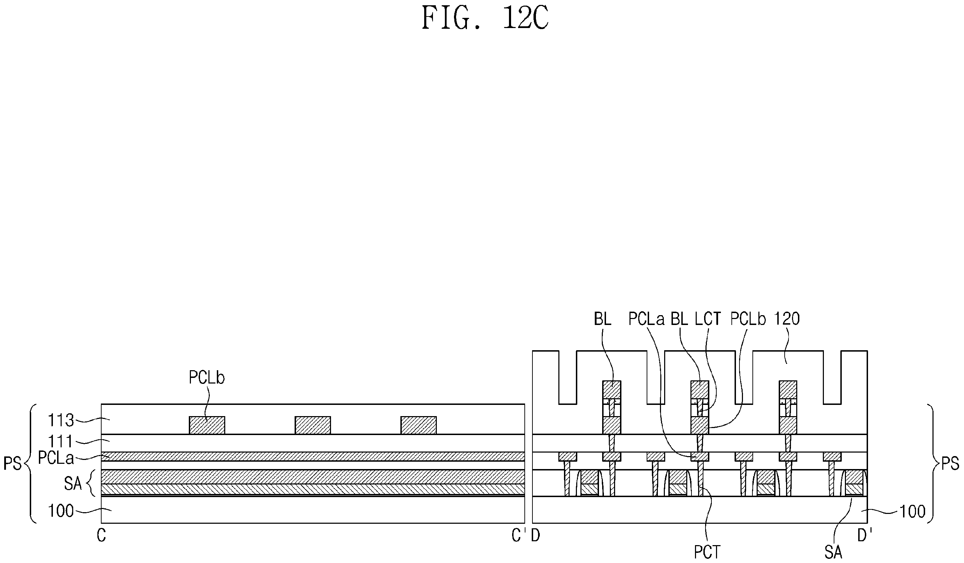

FIGS. 12A to 22A are plan views of stages in a method of manufacturing a semiconductor memory device according to some example embodiments of the present disclosure. FIGS. 12B to 22B are cross-sectional views along lines A-A' and B-B' of FIGS. 12A to 22A. FIGS. 12C to 22C are cross-sectional views along lines C-C' and D-D' of FIGS. 12A to 22A.

Referring to FIGS. 12A, 12B, and 12C, the peripheral circuit structure PS including the core and peripheral circuits SA and PC may be formed on the semiconductor substrate 100. The core and peripheral circuits SA and PC may include NMOS and PMOS transistors integrated on the semiconductor substrate 100.

The peripheral circuit insulating layers 111 and 113 may be formed on the entire surface of the semiconductor substrate 100. The peripheral circuit insulating layers 111 and 113 may cover the core and peripheral circuits SA and PC, and the peripheral circuit wires PCLa and PCLb on the semiconductor substrate 100. The peripheral circuit insulating layers 111 and 113 may include multi-layered insulating layers. The peripheral circuit insulating layers 111 and 113 may include, e.g., a silicon oxide layer, a silicon nitride layer, a silicon oxynitride layer, and/or a low dielectric layer.

The lower contact plugs LCT and peripheral circuit wirings PCLa and PCLb may be formed in the peripheral circuit insulating layers 111 and 113. The lower contact plugs LCT and the peripheral circuit wirings PCLa and PCLb may be electrically connected to the core and peripheral circuits SA and PC.

The bit lines BL may be formed on the peripheral circuit insulating layers 111 and 113. The bit lines BL may extend in the second direction D2 and may be spaced apart from each other in the first direction D1.

Forming the bit lines BL may include depositing a conductive layer on the peripheral circuit insulating layers 111 and 113 and patterning a portion of the conductive layer and the peripheral circuit insulating layers 111 and 113 in the cell array region CAR to form the bit lines BL in the cell array region CAR. While forming the bit lines BL, lower conductive patterns (refer to LCP of FIG. 5D) may be formed by patterning the lower conductive layer and the lower insulating layer in the peripheral circuit region PCR. The lower conductive patterns (refer to LCP of FIG. 5D) may be connected to the peripheral circuit PC through lower contact plugs LCT and the peripheral circuit lines PCLa and PCLb.

Referring to FIGS. 12A, 12B, and 12C, after forming the bit lines BL, the first insulating layer 120 defining a gap region may be formed between the bit lines BL. The first insulating layer 120 may have a substantially uniform thickness and be deposited on the entire surface of the semiconductor substrate 100. A deposition thickness of the first insulating layer 120 may be less than half of a distance between adjacent bit lines BL. As the first insulating layer 120 is deposited in this way, a gap region may be defined by the first insulating layer 120 between the bit lines BL. The gap region may extend parallel to the bit lines BL in the second direction D2.

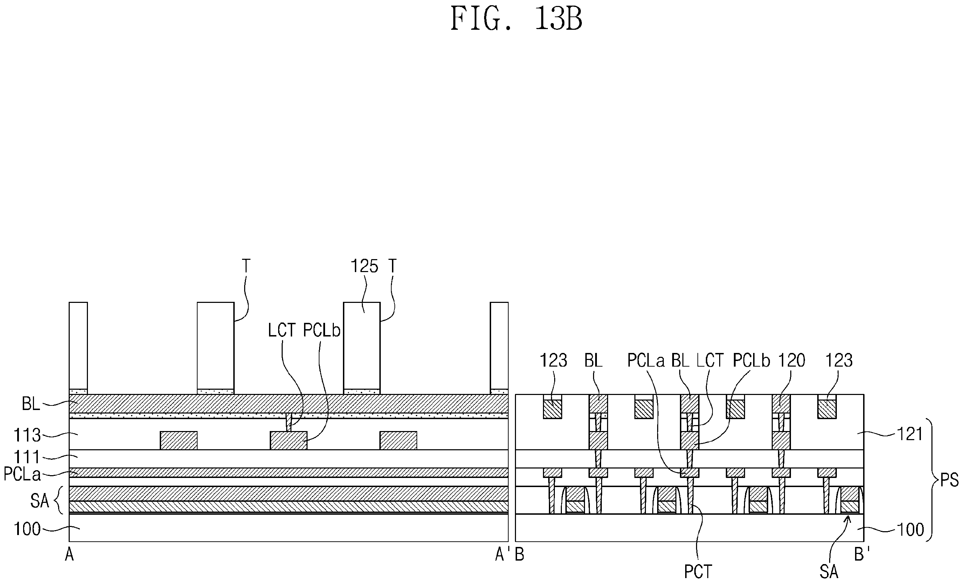

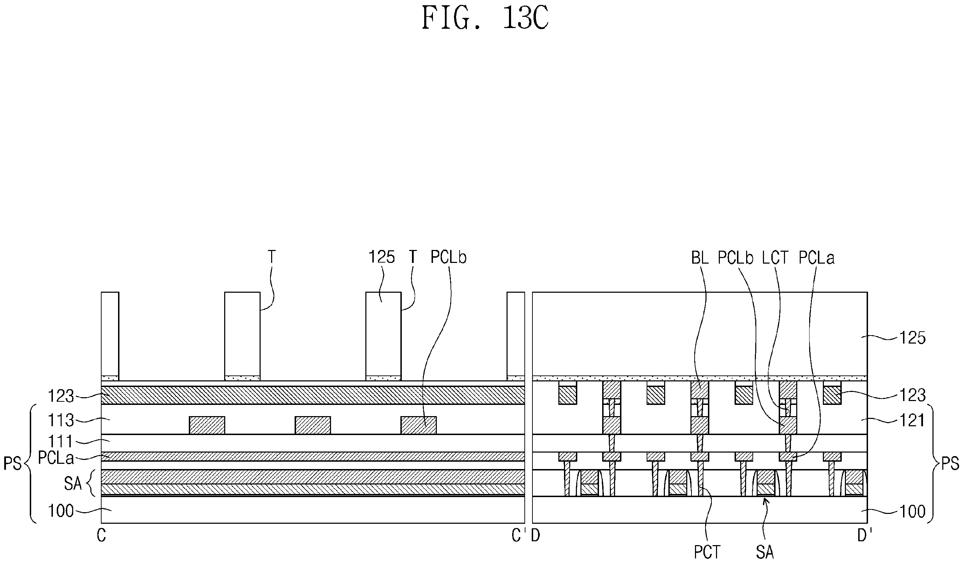

Referring to FIGS. 13A, 13B, and 13C, after forming the first insulating layer 120, the shielding lines 123 may be formed on the first insulating layer 120 to fill the gap regions. The shielding lines 123 may be formed between the bit lines BL.

Forming the shielding lines 123 may include forming a shielding layer on the first insulating layer 120 to fill the gap region and recessing an upper surface of the shielding layer. Upper surfaces of the shielding lines 123 may be positioned at a lower level than upper surfaces of the bit lines BL.

When the shielding layer is deposited on the first insulating layer 120 using a chemical vapor deposition method, a discontinuous boundary surface, e.g., a seam, may be formed due to a step coverage property. In addition to this, when step coverage characteristics are poor, voids or air gaps may be formed in the gap region due to over-hang.

For example, the shielding lines 123 may include a metal material, e.g., tungsten (W), titanium (Ti), nickel (Ni), or cobalt (Co). In another example, the shielding lines 123 may include a conductive two-dimensional (2D) material, e.g., graphene.

For example, forming the shielding lines 123 may be omitted, and the first insulating layer 120 may be filled between the bit lines BL. In another example, the first insulating layer 120 may include air gaps between the bit lines BL.

After forming the shielding lines 123, forming a capping insulating layer on the shielding lines 123, and planarizing the capping insulating layer and the first insulating layer 120 so that upper surfaces of the bit lines BL are exposed may be performed. Accordingly, the first insulating patterns 121 may be formed between the bit lines BL and the shielding lines 123.

Sequentially, the separation insulating pattern 125 may be formed on the first insulating patterns 121 and the bit lines BL. The separation insulating pattern 125 may define trenches T that extend in the first direction D1 and are spaced apart from each other in the second direction D2. The trenches T may be formed across the bit lines BL and may expose portions of the bit lines BL. An etch stop layer may be interposed between the separation insulating pattern 125 and the bit lines BL.

According to embodiments, a distance between the active patterns AP may vary depending on a width of the separation insulating pattern 125 (i.e., corresponding to a distance between the trenches T). In addition, a distance between the first and second word lines WL1 and WL2 may vary depending on the width of the trenches T.

The separation insulating pattern 125 may be formed of an insulating material having etch selectivity with respect to the first insulating pattern 121. The separation insulating pattern 125 may be formed of, e.g., a silicon oxide layer, a silicon nitride layer, a silicon oxynitride layer, and/or a low dielectric layer.

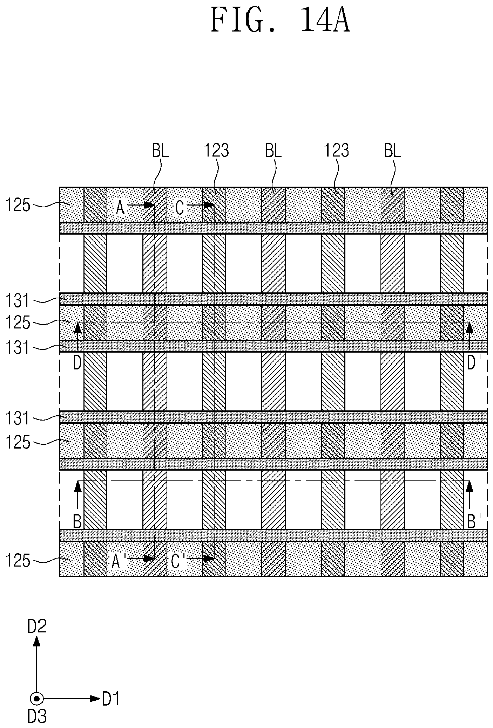

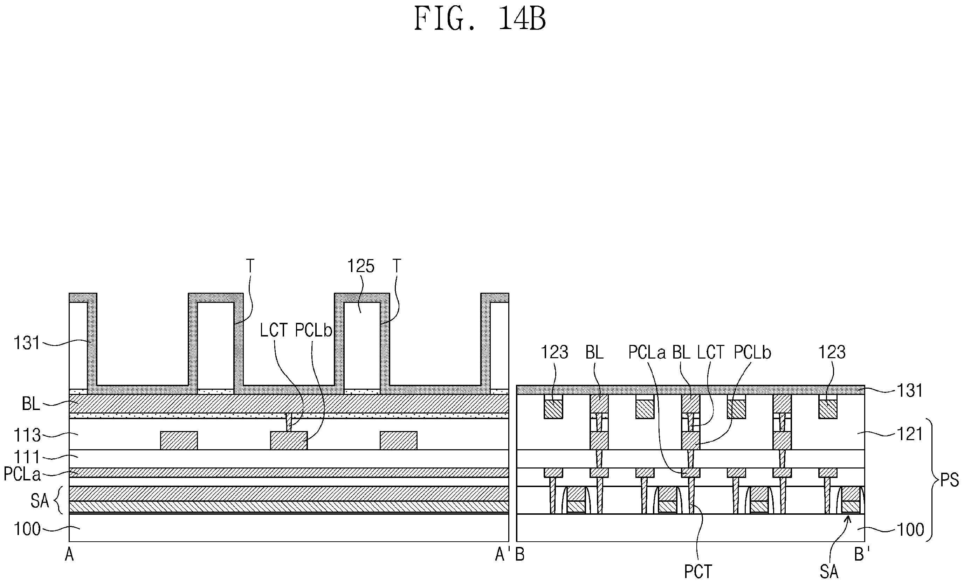

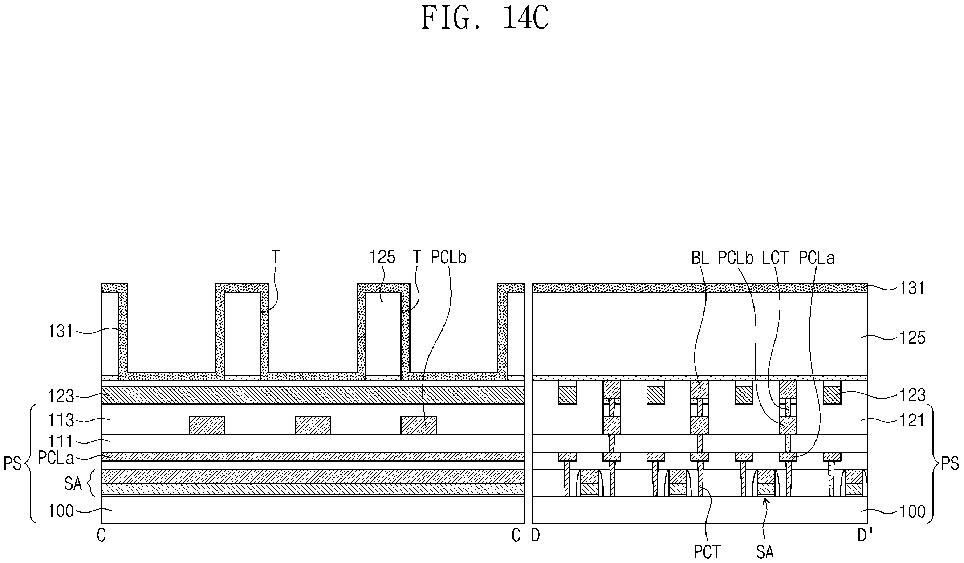

Referring to FIGS. 14A, 14B, and 14C, an active layer 131 conformally covering the separation insulating pattern 125 having the trenches T may be formed. The active layer 131 may be in contact with the bit lines BL in the trenches T and may cover an upper surface and sidewalls of the separation insulating pattern 125.

The active layer 131 may be formed using at least one of, e.g., physical vapor deposition (PVD), thermal CVD, low pressure chemical vapor deposition (LP-CVD), plasma enhanced chemical vapor deposition (PE-CVD) or atomic layer deposition (ALD) technology. The active layer 131 may cover bottom surfaces and inner walls of the trenches T with a substantially uniform thickness. A thickness of the active layer 131 may be less than half of a width of the trench T. For example, the active layer 131 may be deposited to a thickness of several to several tens of nm, e.g., 1 nm to 30 nm or 1 nm to 10 nm. The active layer 131 may include, e.g., a semiconductor material, an oxide semiconductor material, or a two-dimensional semiconductor material. The active layer 131 may include, e.g., silicon, germanium, silicon-germanium, or indium gallium zinc oxide (IGZO). In one example, the active layer 131 may be a polysilicon layer.

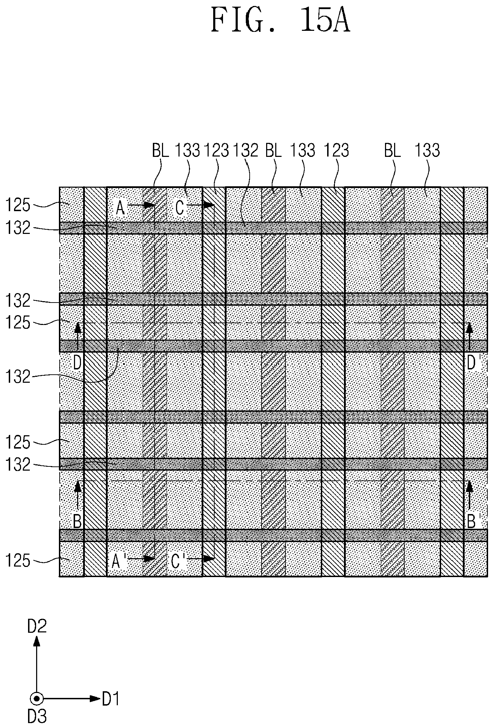

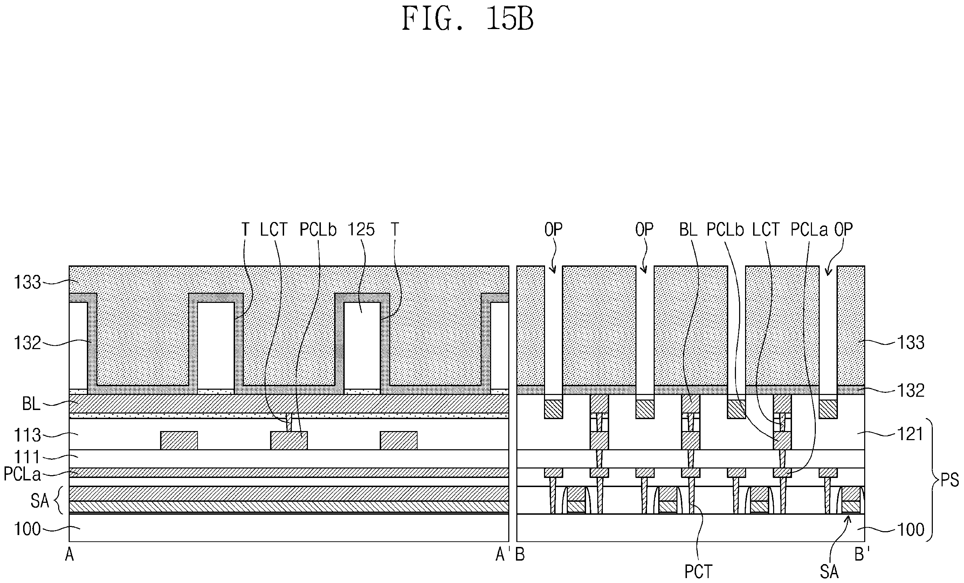

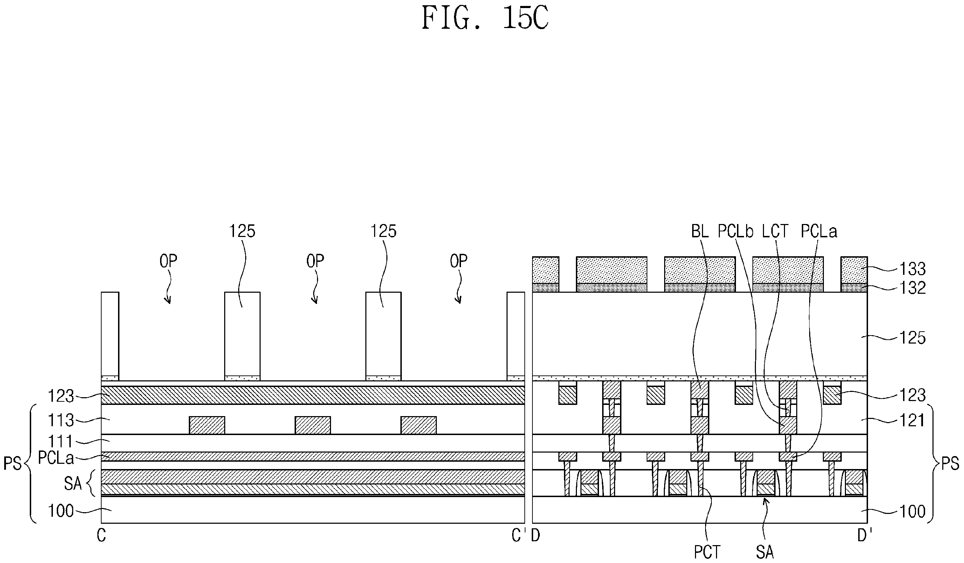

Referring to FIGS. 15A, 15B, and 15C, a first sacrificial layer 133 filling the trenches T may be formed on the active layer 131. The first sacrificial layer 133 may have a substantially flat upper surface. The first sacrificial layer 133 may be formed of an insulating material having etch selectivity with respect to the separation insulating pattern 125. For example, the first sacrificial layer 133 may be one of insulating materials and a silicon oxide layer formed using a spin on glass (SOG) technology.

Subsequently, a mask pattern may be formed on the first sacrificial layer 133. The mask pattern may be disposed across the separation insulating pattern 125 and may have openings having a long axis in the second direction D2. The openings of the mask pattern may be spaced apart from each other in the first direction D1. The openings of the mask pattern may be positioned between the bit lines BL when viewed in a plan view.

Thereafter, the first sacrificial layer 133 and the active layer 131 may be sequentially etched using the mask pattern as an etch mask to form openings OP that expose the first insulating pattern 121 between the bit lines BL. The openings OP may overlap the shielding lines 123 when viewed in a plan view.

As the openings OP are formed, preliminary active patterns 132 may be formed in the respective trenches T. The preliminary active patterns 132 may be spaced apart from each other in the first direction D1. After forming the preliminary active patterns 132, the mask pattern may be removed, e.g., by an ashing process.

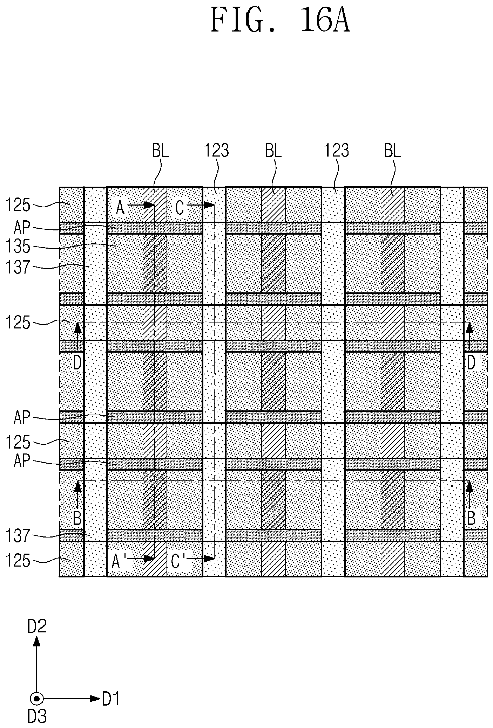

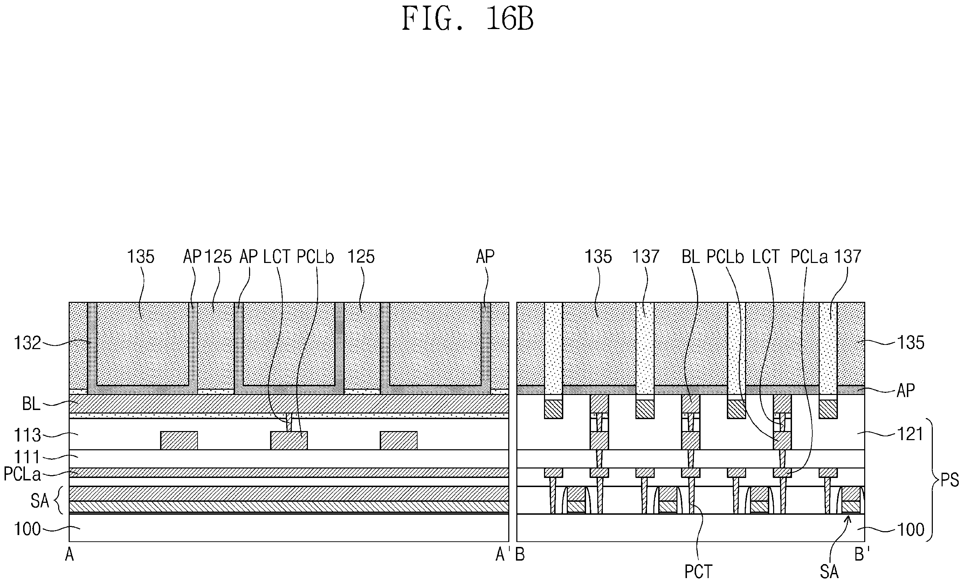

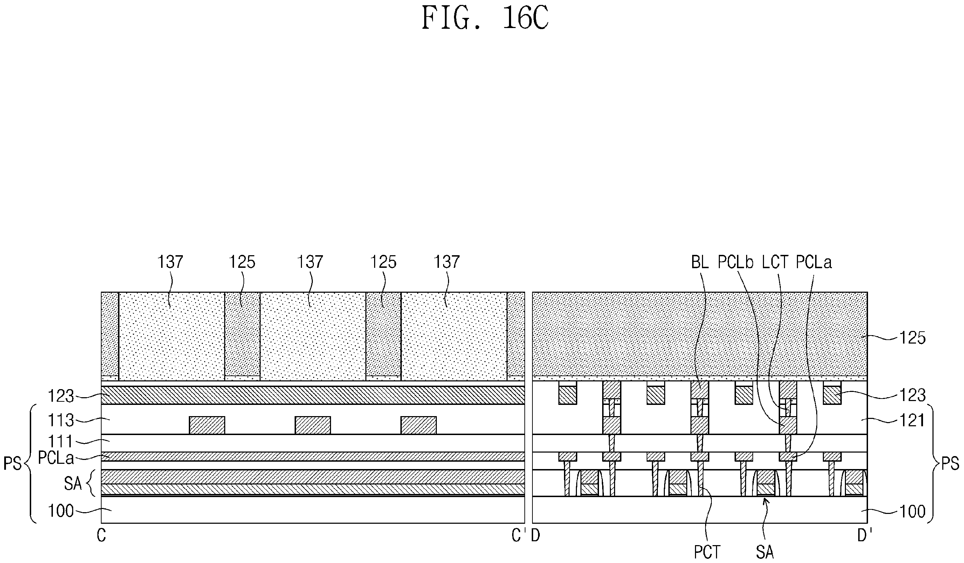

Referring to FIGS. 16A, 16B, and 16C, after the preliminary active patterns 132 are formed, a second sacrificial layer filling the openings OP may be formed. The second sacrificial layer may be formed of the same material as the first sacrificial layer 133.

After forming the second sacrificial layer, a planarization process may be performed on the first sacrificial layer 133, the second sacrificial layer, and the preliminary active patterns 132 to expose an upper surface of the separation insulating pattern 125. Accordingly, the active patterns AP, first sacrificial patterns 135, and second sacrificial patterns 137 may be formed.

The active patterns AP may be spaced apart from each other in the first direction D1 and the second direction D2. Each of the active patterns AP may include a horizontal channel portion in contact with the bit line BL, and a pair of vertical channel portions extending from the horizontal channel portion and in contact with sidewalls of each trench T. The active patterns AP may be spaced apart in the second direction D2 by the separation insulating pattern 125 and may be spaced apart in the first direction D1 by the second sacrificial patterns 137.

The first sacrificial pattern 135 may be formed on each active pattern AP, and the second sacrificial pattern 137 may be formed between the active patterns AP adjacent to each other in the first direction D1 and between the first sacrificial patterns 135. After forming the active patterns AP, the first and second sacrificial patterns 135 and 137 may be removed using an etching recipe having etch selectivity with respect to the separation insulating pattern 125 and the active patterns AP. Accordingly, surfaces of the active patterns AP may be exposed.

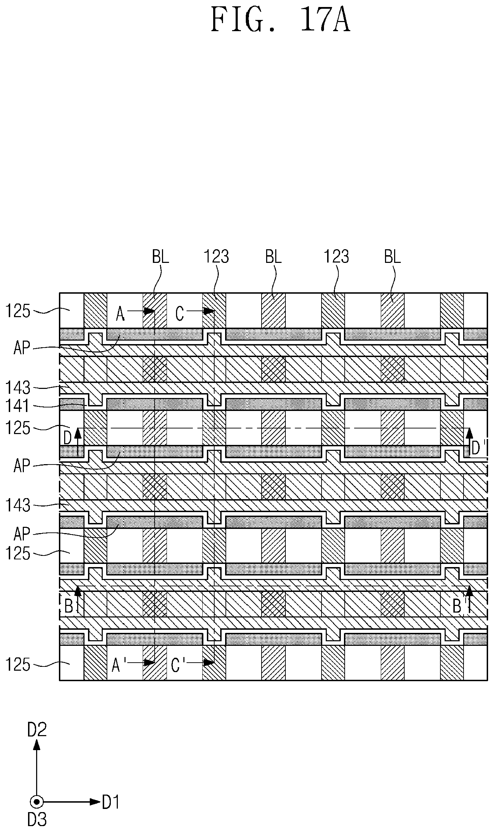

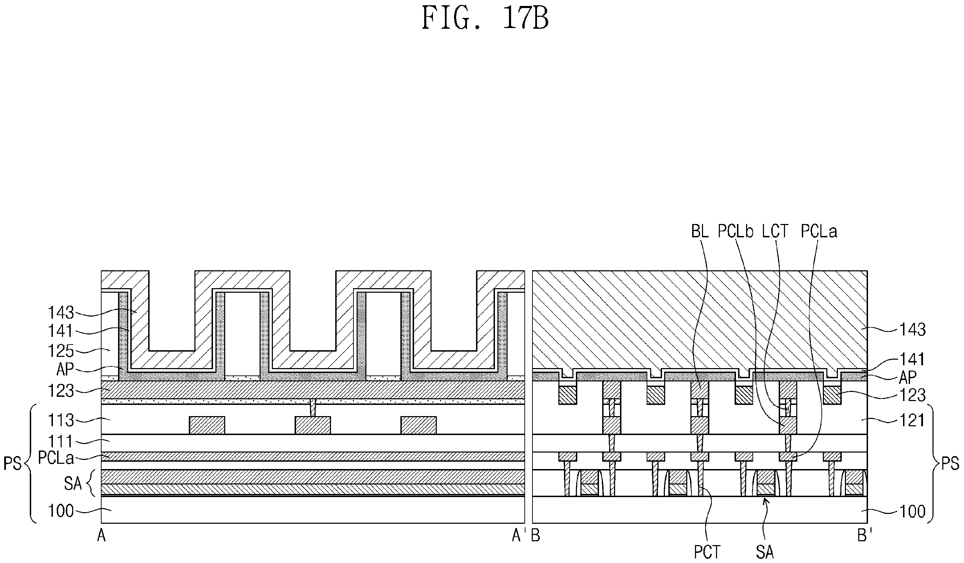

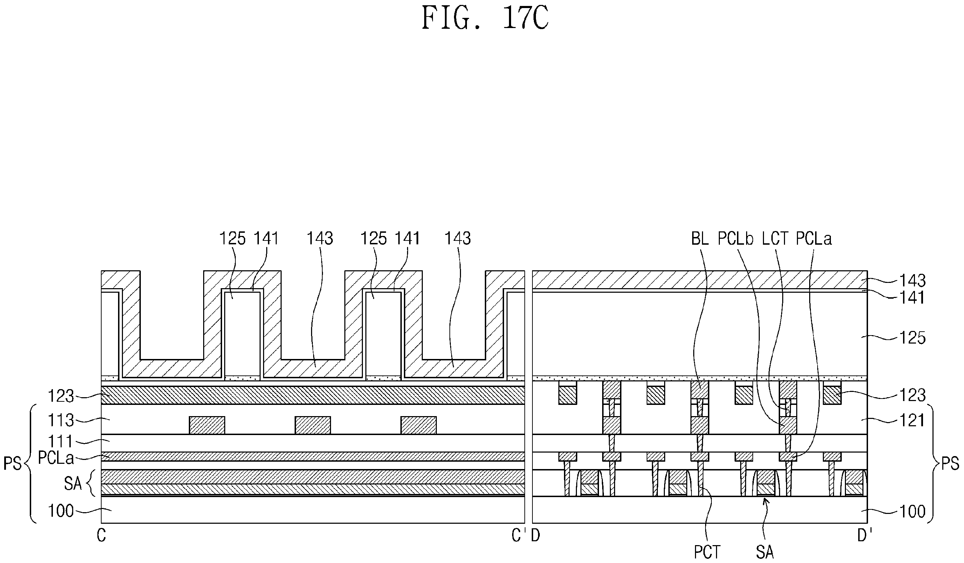

Referring to FIGS. 17A, 17B, and 17C, a gate insulating layer 141 and a gate conductive layer 143 conformally covering the active patterns AP may be sequentially deposited.

The gate insulating layer 141 and the gate conductive layer 143 may be formed using at least one of, e.g., physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) techniques.

The gate insulating layer 141 and the gate conductive layer 143 may cover the horizontal and vertical channel portions of the active patterns AP with a substantially uniform thickness. The sum of the thicknesses of the gate insulating layer 141 and the gate conductive layer 143 may be less than half of a width of the trench T.

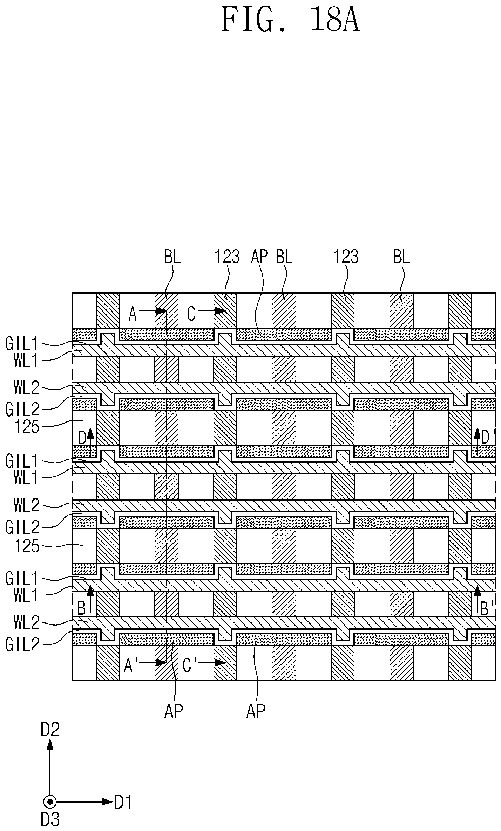

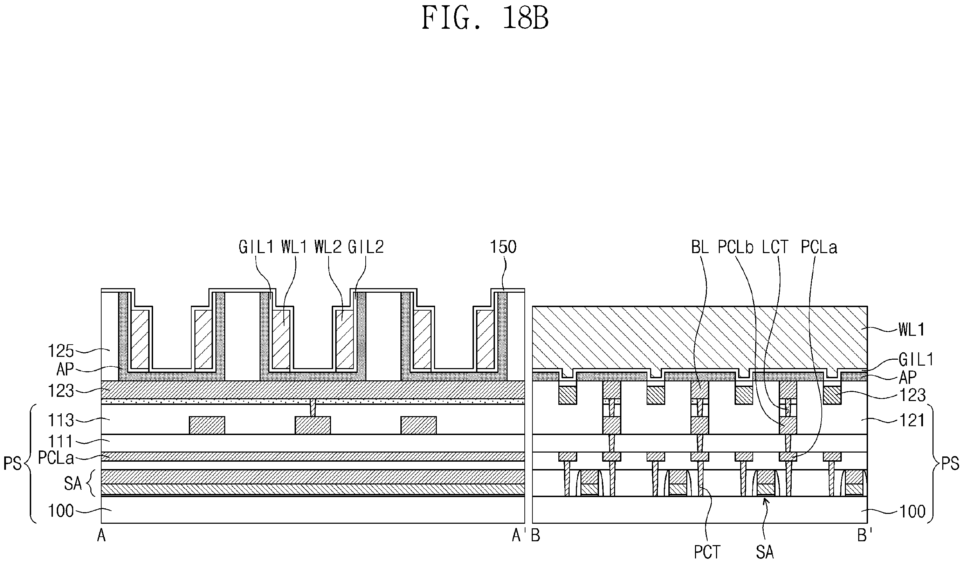

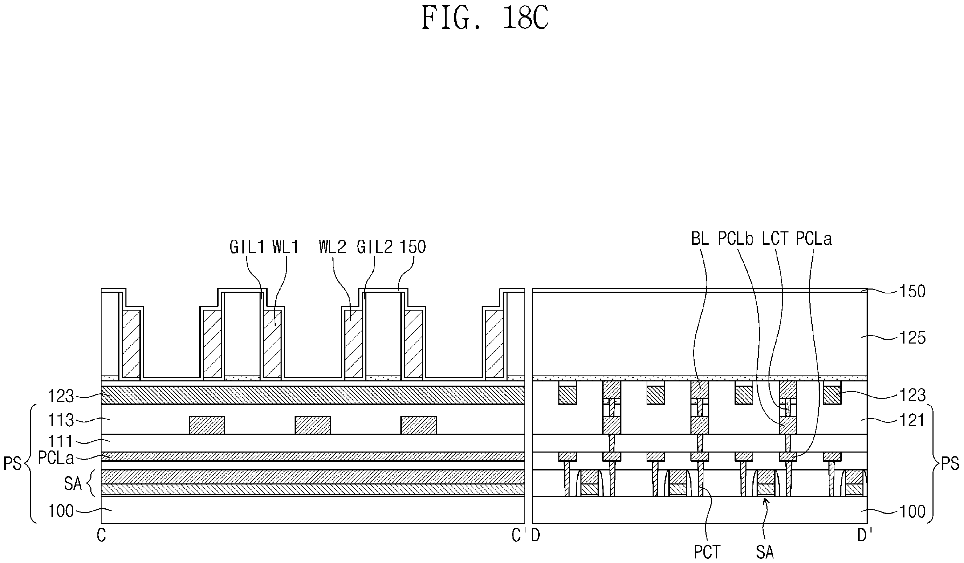

Referring to FIGS. 18A, 18B, and 18C, an anisotropic etching process may be performed on the gate conductive layer 143 to form a pair of first and second word lines WL1 and WL2 separated from each other in each trench T. During the anisotropic etching process of the gate conductive layer 143, upper surfaces of the first and second word lines WL1 and WL2 may be lower than the upper surface of the active pattern AP. Alternatively, an etching process of recessing the upper surfaces of the first and second word lines WL1 and WL2 may be additionally performed.

In another example, during the anisotropic etching process on the gate conductive layer 143, the gate insulating layer may be patterned to expose the active pattern AP. Accordingly, first and second gate insulating patterns GIL1 and GIL2 may be formed. In yet another example, during the anisotropic etching process on the gate conductive layer 143, the gate insulating layer 141 and the active pattern AP may be sequentially etched to expose the bit line BL. Accordingly, as shown in FIG. 6C, a pair of first and second active patterns AP1 and AP2 separated from each other may be formed in each trench T.

Subsequently, the first capping layer 150 may be conformally formed on the entire surface of the semiconductor substrate 100. For example, the first capping layer 150 may be formed of silicon nitride (SiN), silicon oxynitride (SiON), silicon carbide (SiC), silicon carbon nitride (SiCN), or a combination thereof.

For example, the first capping layer 150 may cover surfaces of the active patterns AP between the pair of word lines WL1 and WL2. In another example, the spacers SP1 and SP2 may be removed before forming the first capping layer 150. In this case, the first capping layer 150 may directly cover the surfaces of the first and second word lines WL1 and WL2.

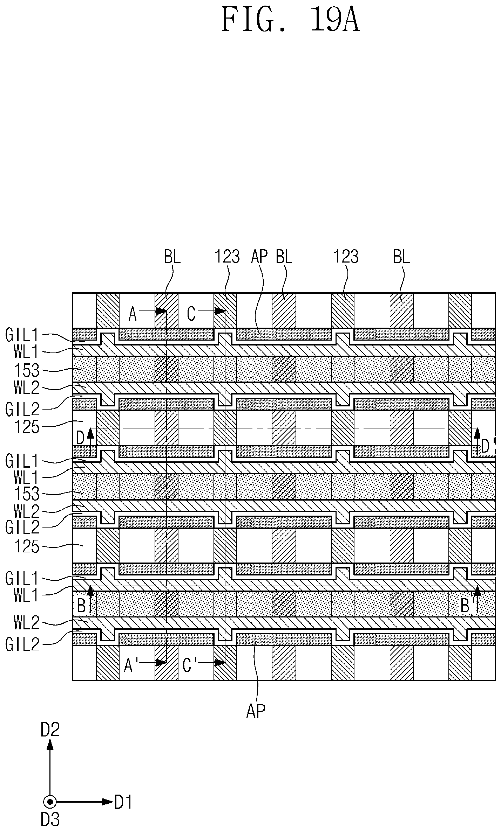

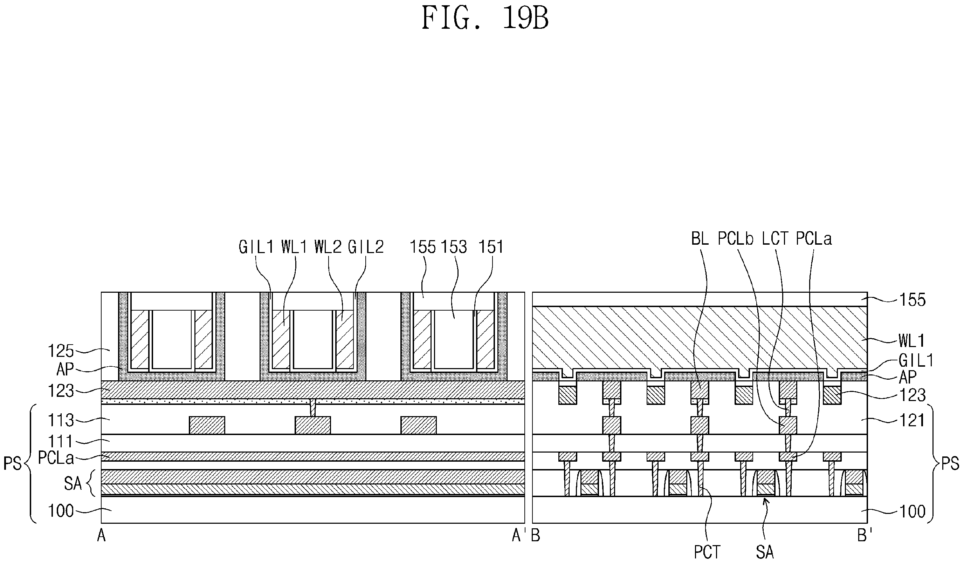

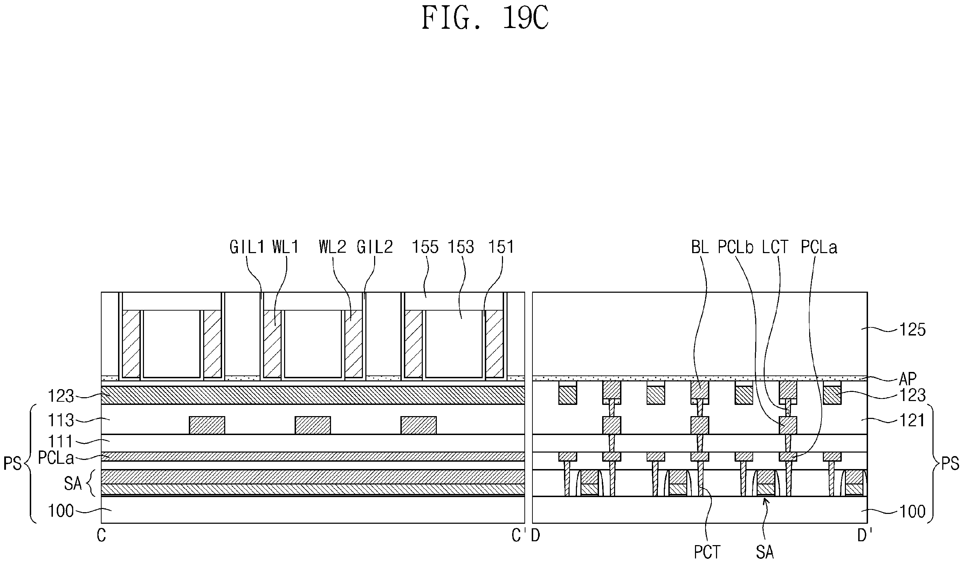

Referring to FIGS. 19A, 19B, and 19C, a second insulating layer filling the trench T in which the first capping layer 150 is formed, and a second capping layer may be sequentially formed. The second insulating layer may be formed of an insulating material different from that of the first capping layer 150. The second capping layer may be formed of the same material as the first capping layer 150, and the second capping layer may be omitted.

Then, a planarization process may be performed on the first capping layer 150, the second insulating layer, and the second capping layer so that an upper surface of the separation insulating pattern 125 is exposed. Accordingly, the first capping pattern 151, the second insulating pattern 153, and the second capping pattern 155 may be formed. An upper surface of the second capping pattern 155 may be coplanar with an upper surface of the separation insulating pattern 125.

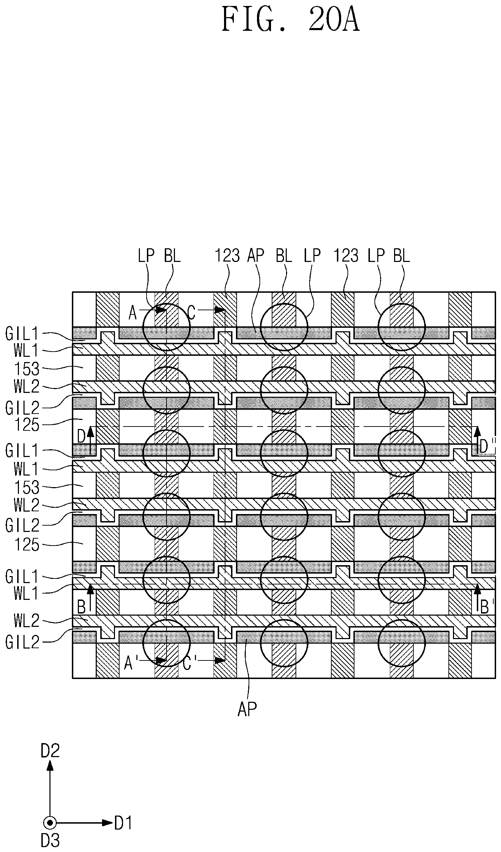

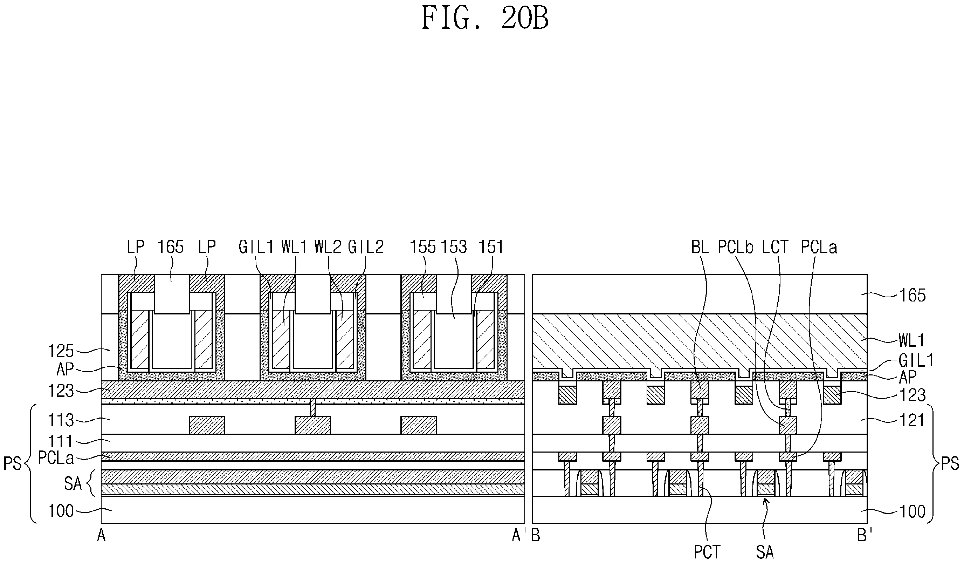

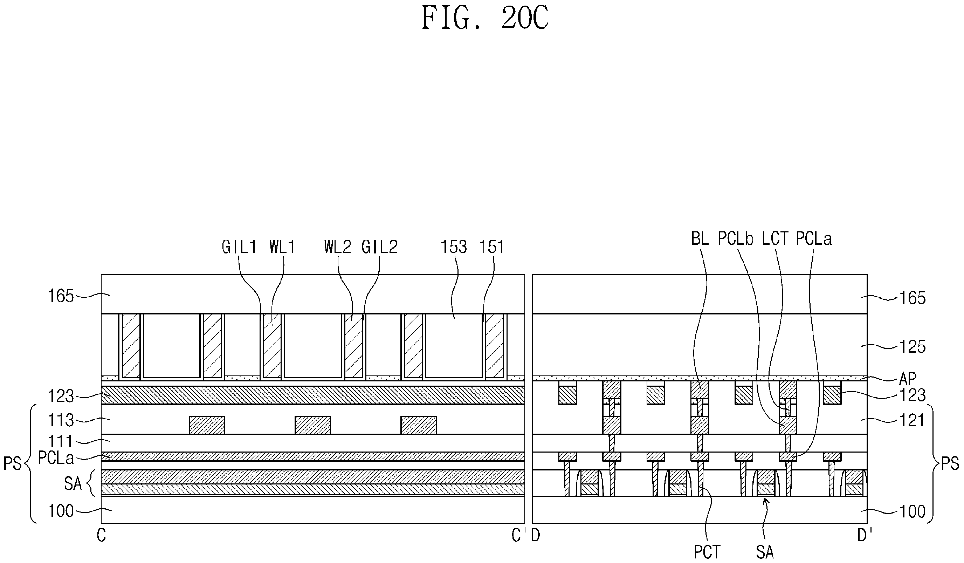

Referring to FIGS. 20A, 20B, and 20C, an etching process may be performed on portions of the active patterns AP to form recess regions formed between the separation insulating pattern 125 and the first and second gate insulating patterns GIL1 and GIL2. Accordingly, the upper surfaces of the active patterns AP may be positioned at a level lower than the upper surface of the separation insulating pattern 125. In addition, the upper surfaces of the active patterns AP may be positioned at a different level from the upper surfaces of the first and second word lines WL1 and WL2.

Subsequently, a conductive layer filling the recess regions may be formed on the entire surface of the semiconductor substrate 100. The conductive layer may be formed of, e.g., doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or combinations thereof.

Thereafter, the conductive layer may be patterned to form landing pads LP in contact with vertical portions of the active patterns AP. The landing pads LP may have various shapes, e.g., a circular shape, an elliptical shape, a rectangular shape, a square shape, a rhombic shape, and a hexagonal shape, when viewed in a plan view. After forming the landing pads LP and upper conductive patterns UCP, a third insulating pattern 165 filling a space between the landing pads LP may be formed.

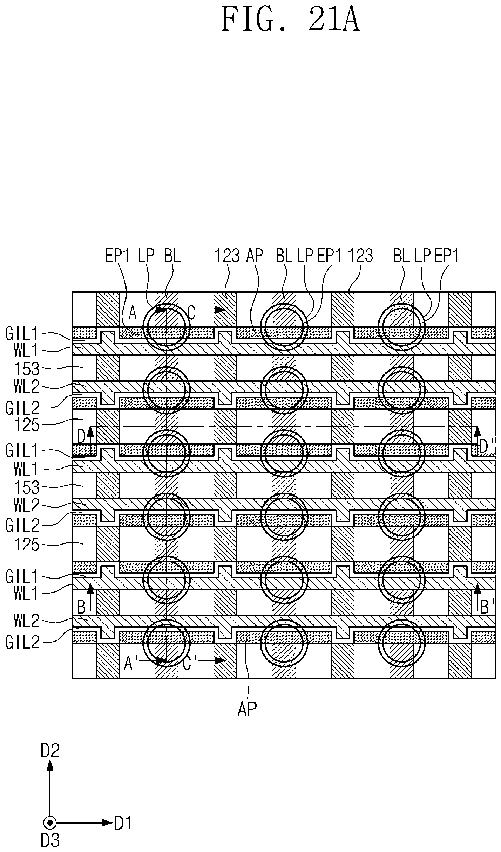

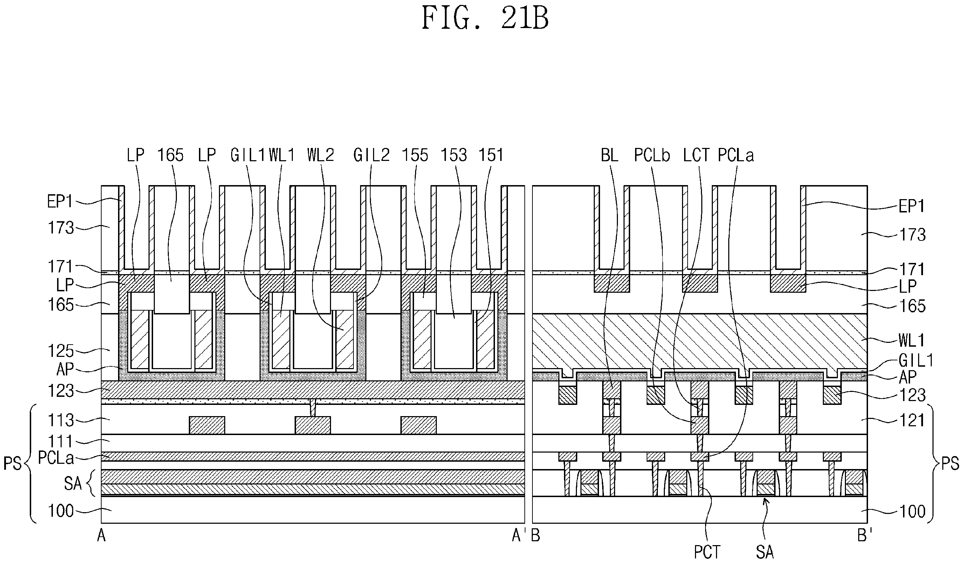

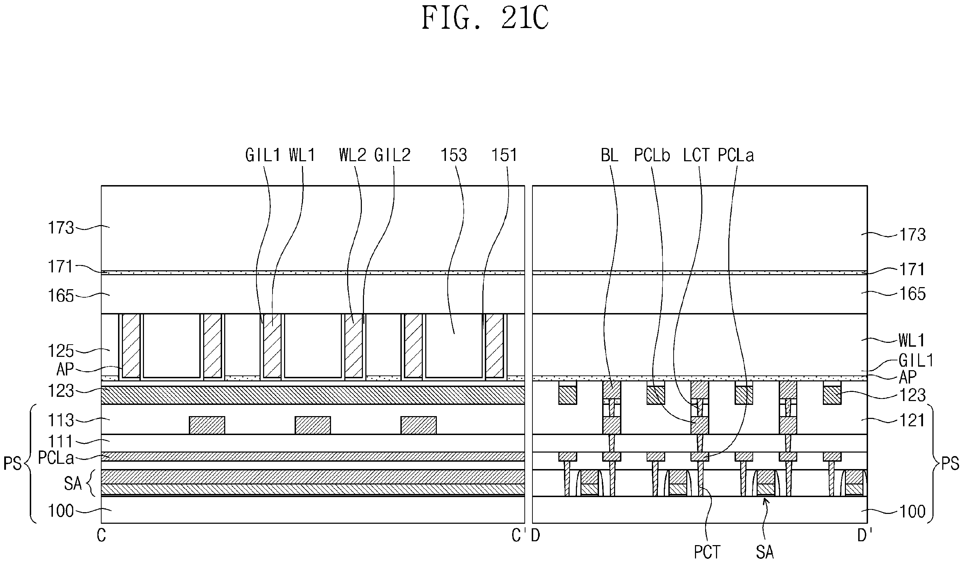

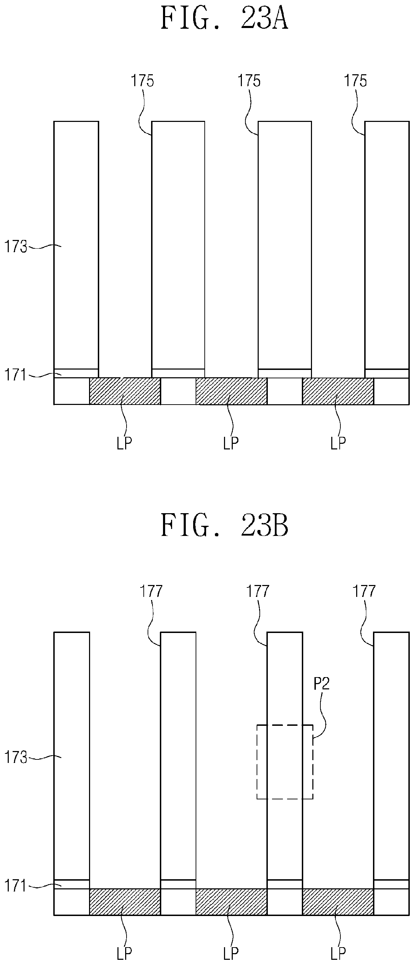

Referring to FIGS. 21A, 21B, and 21C, the etch stop layer 171 and the mold insulating layer 173 covering the landing pads LP may be sequentially formed. Next, the first electrode patterns EP1 may be formed through the mold insulating layer 173 and the etch stop layer 171 and connected to the landing pads LP, respectively. The first electrode patterns EP1 may have a cylindrical shape. A method of forming the first electrode patterns EP1 will be described in more detail with reference to FIGS. 23A to 23E.

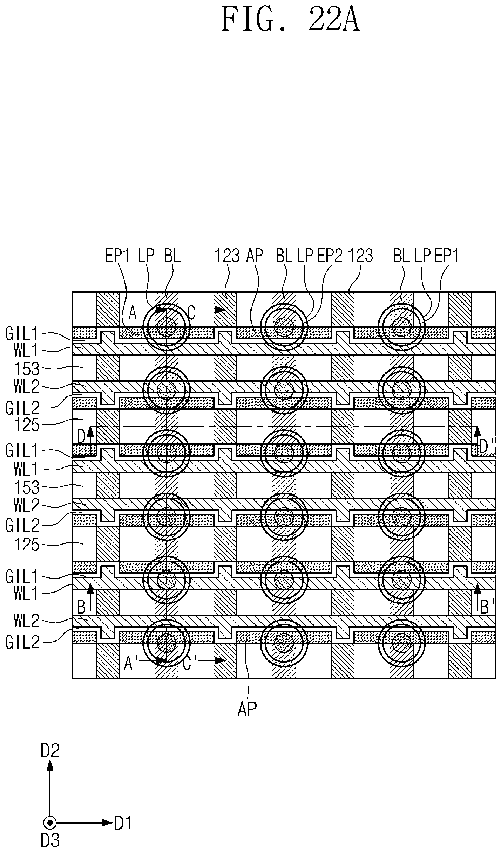

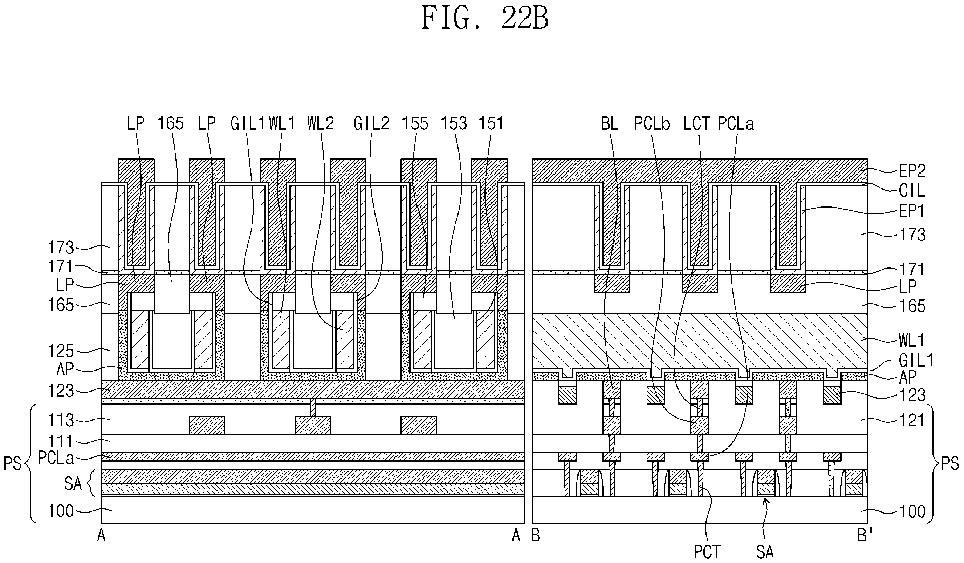

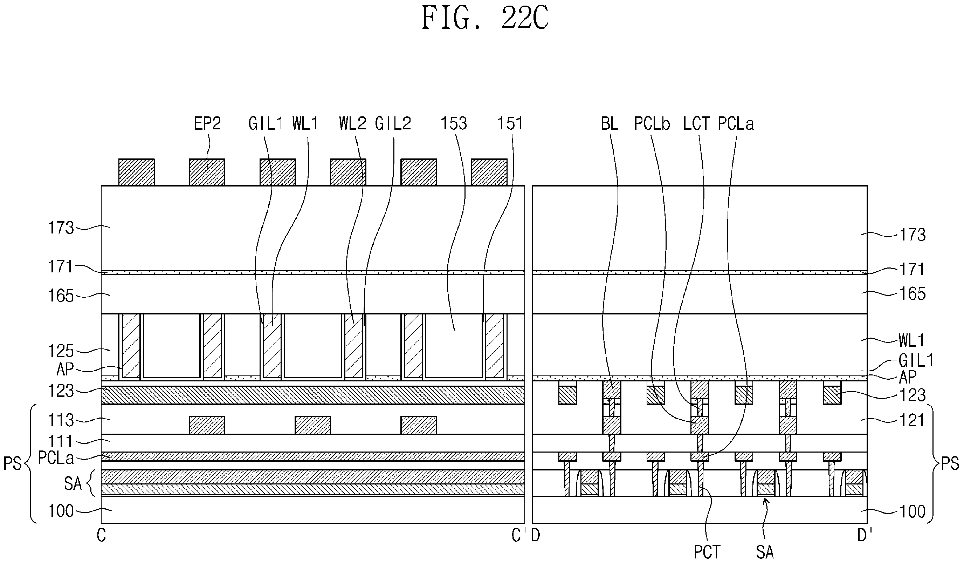

Referring to FIGS. 22A, 22B, and 22C, the capacitor dielectric layer CIL may be formed to cover upper surfaces of the first electrode patterns EP1 and an upper surface of the mold insulating layer 173 with a uniform thickness.

Subsequently, second electrode patterns EP2 may be formed on the capacitor dielectric layer CIL. Each of the second electrode patterns EP2 may be formed on the capacitor dielectric layer CIL and may include a line portion extending in the first direction D1 on the first electrode patterns EP1.

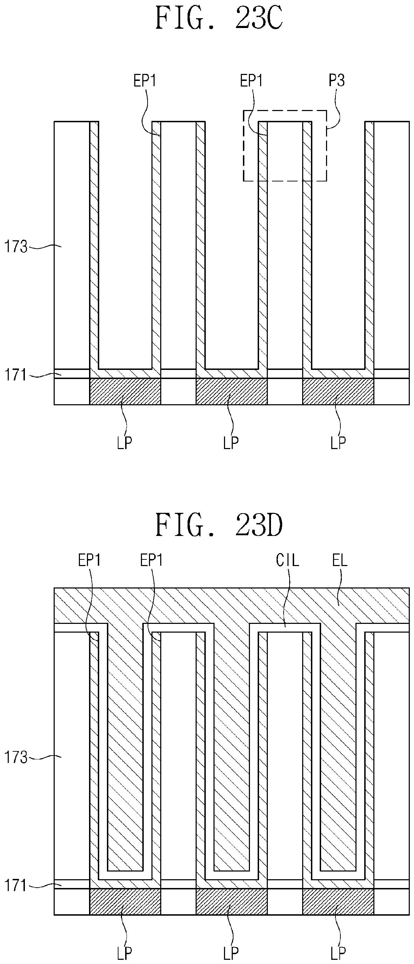

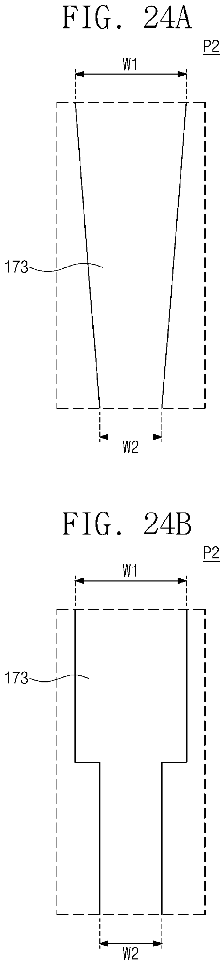

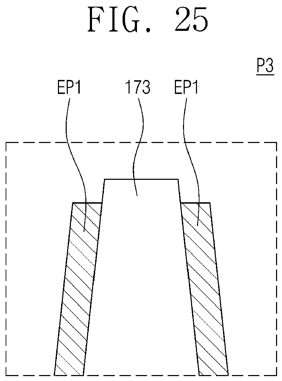

FIGS. 23A to 23E are views of stages in a method of manufacturing a capacitor of a semiconductor memory device according to some example embodiments of the present disclosure. FIGS. 24A and 24B are enlarged views of portion `P2' of FIG. 23B. FIG. 25 is an enlarged view of portion `P3' of FIG. 23C.

Referring to FIG. 23A, portions of the mold insulating layer 173 and the etch stop layer 171 may be patterned to form preliminary holes 175 exposing the landing pads LP. The preliminary holes 175 may extend in a direction perpendicular to an upper surface of the first semiconductor substrate 100. The preliminary holes 175 may have various shapes, e.g., a rectangle, a circle, or an ellipse when viewed in a plan view. In addition, the preliminary holes 175 may be arranged in a zigzag or honeycomb shape.

Referring to FIG. 23B, an isotropic etching process may be performed on the mold insulating layer 173 having the preliminary holes 175. Accordingly, capacitor holes 177 having a larger diameter than that of the preliminary holes 175 may be formed.

The mold insulating layer 173 may be formed of an insulating material doped with impurities, and a composition ratio thereof may gradually change from a lower surface to an upper surface thereof. In this case, during the isotropic etching process for the mold insulating layer 173, an etching amount may be different from an upper portion to a lower portion of the capacitor hole. In this case, as shown in FIGS. 24A and 24B, the upper portion of the mold insulating layer 173 may have a greater width W1 than a width W2 of the lower portion of the mold insulating layer 173.

For example, as shown in FIG. 24A, the capacitor holes 177 may have inclined sidewalls. In another example, as shown in FIG. 24B, the capacitor holes 177 may have stepped sidewalls.

Referring to FIG. 23C, a first metal layer may be deposited to cover the surface of the capacitor holes 177 and the upper surface of the mold insulating layer 173 with a uniform thickness. For example, the first metal layer may include a metal, e.g., tungsten, titanium, and tantalum and/or a conductive metal nitride, e.g., titanium nitride, tantalum nitride, and tungsten nitride.

After forming a sacrificial layer completely filling the capacitor holes 177 on the first metal layer, a planarization process (e.g., a chemical mechanical polishing (CMP) process or an anisotropic etching process) may be performed on the first metal layer to expose the upper surface of the mold insulating layer 173. Accordingly, the first metal layer may be separated into a plurality of first electrode patterns EP1. Referring to FIG. 25, upper surfaces of the first electrode patterns EP1 may be positioned at a level lower than the upper surface of the mold insulating layer 173.

Referring to FIG. 23D, the capacitor dielectric layer CIL and the second metal layer EL may be sequentially deposited on the first electrode patterns EP1.

The capacitor dielectric layer CIL may cover the surfaces of the first electrode patterns EP1 and the upper surface of the mold insulating layer 173 with a uniform thickness. The capacitor holes 177 in which the first electrode patterns EP1 are formed may not be completely filled.

The capacitor dielectric layer CIL may include a ferroelectric material, an antiferroelectric material, a paraelectric material, or a combination thereof. For example, the capacitor dielectric layer CIL may include a single layer selected from metal oxides, e.g., HfO₂, ZrO₂, Al₂O₃, La₂O₃, Ta₂O₃, and TiO₂, and a dielectric material with a perovskite structure, e.g., SrTiO₃ (STO), (Ba,Sr)TiO₃ (BST), BaTiO₃, PZT, PLZT, or a combination thereof.

The second metal layer EL may completely fill the capacitor holes 177 in which the first electrode patterns EP1 and the capacitor dielectric layer CIL are formed. For example, the second metal layer EL may include a metal, e.g., tungsten, titanium, and tantalum and/or a conductive metal nitride, e.g., titanium nitride, tantalum nitride, and tungsten nitride.

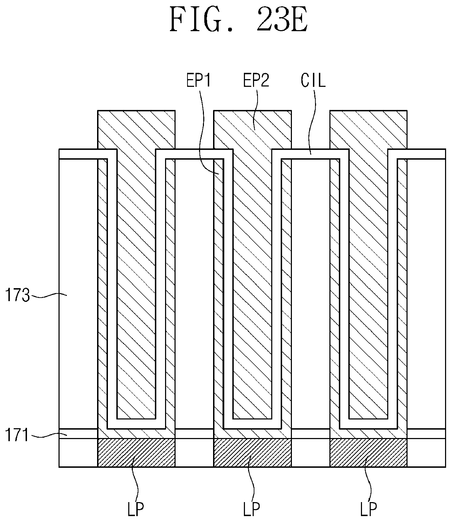

Subsequently, referring to FIG. 23E, a mask pattern may be formed on the second metal layer EL, and an anisotropic etching process may be performed on the second metal layer EL using the mask pattern. Accordingly, as shown in FIG. 22A, second metal patterns EP2 having line portions extending in the first direction D1 may be formed.

By way of summation and review, example embodiments provide a semiconductor memory device with improved integration and electrical characteristics. That is, according to some example embodiments, in a semiconductor memory device including vertical channel transistors, the capacitor as the data storage element may include a ferroelectric material. As the ferroelectric capacitor has non-volatile characteristics, data retention characteristics may be secured, the cap area may be reduced, and the cap height may be lowered, e.g., facilitating manufacturing. In addition, a channel material having poor leakage current characteristics may be used in the vertical channel transistors. That is, the channel material of the vertical channel transistors may be formed using the deposition process, which may be advantageous in terms of manufacturing process and integration, e.g., cell and core may overlap.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor memory device, comprising:
a bit line extending in a first direction;
an active pattern on the bit line, the active pattern including first and second vertical portions facing each other in the first direction and a horizontal portion connecting the first and second vertical portions;
first and second word lines on the horizontal portion between the first and second vertical portions, the first and second word lines extending in a second direction crossing the first direction;
a gate insulating pattern between the first and second word lines and the active pattern; and
a capacitor connected to each of the first and second vertical portions, the capacitor including:
a first electrode pattern connected to one of the first and second vertical portions,
a second electrode pattern on the first electrode pattern, and
a ferroelectric pattern between the first electrode pattern and the second electrode pattern.

2. The semiconductor memory device as claimed in claim 1, wherein the first electrode pattern includes a bottom portion connected to the one of the first and second vertical portions and a side wall portion extending from the bottom portion.

3. The semiconductor memory device as claimed in claim 2, wherein the second electrode pattern includes:
a line portion extending in the second direction; and
a filler portion filling a space defined by the bottom portion and the side wall portion of the first electrode pattern.

4. The semiconductor memory device as claimed in claim 2 or claim 3, wherein the ferroelectric pattern covers the bottom portion and the side wall portion of the first electrode pattern with a uniform thickness.

5. The semiconductor memory device as claimed in any preceding claim, wherein the ferroelectric pattern includes HfO₂, HfSiO₂, HfAlO₂, HfSiON, HfZnO, HfZrO₂, ZrO₂, ZrSiO₂, HfZrSiO₂, ZrSiON, LaAlO, HfDyO₂, or HfScO₂.

6. The semiconductor memory device as claimed in any preceding claim, wherein the active pattern includes polysilicon or metal oxide.

7. The semiconductor memory device as claimed in any preceding claim, further comprising a landing pad between the first electrode pattern and one of the first and second vertical portions, a bottom surface of the landing pad being at a level lower than an upper surface of the gate insulating pattern.

8. The semiconductor memory device as claimed in any preceding claim, wherein a bottom surface of the active pattern is at a lower level than an upper surface of the bit line.

9. The semiconductor memory device as claimed in any preceding claim, wherein:
the bit line has a first width in the second direction, and
the active pattern has a second width greater than the first width in the second direction.

10. The semiconductor memory device as claimed in any preceding claim, further comprising:
a semiconductor substrate; and
a peripheral circuit structure including peripheral circuits on the semiconductor substrate and a lower insulating layer covering the peripheral circuits,
wherein the bit lines are disposed on the peripheral circuit structure.
